# EUROPEAN PATENT APPLICATION

(11) **EP 4 472 055 A1**
(43) Date of publication of application: **04.12.2024**
(21) Application number: 22924225.0
(22) Date of filing: 28.12.2022
(51) Int. Cl.: H02N 2/04

(54) **VIBRATION ACTUATOR**

(30) Priority: 25.01.2022 JP 2022009653
(71) Applicant: CANON KABUSHIKI KAISHA, Tokyo 146-8501 (JP)
(72) Inventor: ARIMITSU, Yasumichi, Tokyo 146-8501 (JP)
(74) Representative: Canon Europe Limited
(86) International application number: PCT/JP2022/048454
(87) International publication number: WO 2023/145378

(57) **Abstract**

A vibration actuator includes: a vibration body 1 including an elastic body 2 and an electric-mechanical energy conversion element 3 joined to the elastic body 2; and a contact body 4 that contacts the vibration body 1. The vibration body 1 and the contact body 4 move relative to each other in a predetermined direction. A vibration-damping member 25 is provided on a predetermined surface of the contact body 4 that is different from a contact surface that contacts the vibration body 1. The vibration-damping member 25 is constituted by a viscoelastic body or by combining the viscoelastic body and a reinforcement member.

## Description

### TECHNICAL FIELD

The present invention relates to a vibration actuator in which a vibration body and a contact body move relative to each other, a contact body unit, an actuator unit using the vibration actuator, an apparatus, a multi-axis stage unit, and an articulated robot.

### BACKGROUND

There have been proposed: a vibration actuator that obtains thrust between a vibration body and a contact body by generating, in the vibration body, vibration in which different vibration modes are combined; and a vibration actuator that changes a frictional force between a vibration body and a contact body by causing excitation in a single vibration mode.

PTL 1 discloses, regarding a vibration motor (corresponding to a vibration actuator) including a vibrator (corresponding to a vibration body) that generates an elliptic motion in which a plurality of different vibrations are synthesized, a configuration with which a vibration generated in a relative movement member (corresponding to a contact body) due to the elliptic motion generated by the vibrator is absorbed by providing a vibration-absorbing member between the relative movement member and a second base member.

### Citation List: Patent Literature

PTL 1: Japanese Patent Laid-Open No. 2000-324865
PTL 2: Japanese Patent Laid-Open No. 2018-140101

### SUMMARY

### Technical Problem.

However, with the configuration disclosed in PTL 1, the output power per volume or per weight tends to be small, and the configuration has a problem in space efficiency. A first reason for this is that the second base member is necessary. The second base member, which is illustrated to be larger than the relative movement member, increases the size of the entirety of the vibration motor and makes reduction in size difficult. A second reason is that a limitation is imposed on an embodiment of the vibration motor. Since the vibration-absorbing member is provided between the relative movement member and the second base member, a surface that can be used for frictional sliding of the relative movement member is inevitably limited. Therefore, the vibration-absorbing member is affixed to a surface that faces a frictional sliding surface, and the surface cannot be used for driving.

The present invention has been made against the background described above, and an object thereof is to suppress unnecessary vibration generated in a vibration actuator and to prevent output power per volume or per weight from becoming small.

### Solution to Problem.

A vibration actuator according to the present invention includes: a vibration body including an elastic body and an electric-mechanical energy conversion element joined to the elastic body; and a contact body that contacts the vibration body. The vibration body and the contact body move relative to each other in a predetermined direction. A vibration-damping member is provided on a predetermined surface of the contact body that is different from a contact surface that contacts the vibration body.

### Advantageous Effects of Invention.

With the present invention, it is possible to suppress unnecessary vibration generated in a vibration actuator and to prevent output power per volume or per weight from becoming small.

### BRIEF DESCRIPTION OF DRAWINGS

Fig. 1A is a view illustrating a schematic configuration of a vibration body.
Fig. 1B is a view illustrating a schematic configuration of the vibration body.
Fig. 1C is a view illustrating a schematic configuration of the vibration body.
Fig. 2A is a view for describing a vibration mode that is excited in the vibration body.
Fig. 2B is a view for describing a vibration mode that is excited in the vibration body.
Fig. 2C is a view for describing the vibration mode that is excited in the vibration body.
Fig. 3A is a view for describing a vibration actuator according to a first embodiment.
Fig. 3B is a view for describing the vibration actuator according to the first embodiment.
Fig. 3C is a view for describing the vibration actuator according to the first embodiment.
Fig. 3D is a view for describing the vibration actuator according to the first embodiment.
Fig. 4A is a view for describing an example of a contact body unit and a vibration body according to the first embodiment.
Fig. 4B is a view for describing an example of the contact body unit and the vibration body according to the first embodiment.
Fig. 4C is a view for describing an example of the contact body unit and the vibration body according to the first embodiment.
Fig. 4D is a view for describing an example of the contact body unit and the vibration body according to the first embodiment.
Fig. 4E is a view for describing an example of the contact body unit and the vibration body according to the first embodiment.
Fig. 4F is a view for describing an example of the contact body unit and the vibration body according to the first embodiment.
Fig. 4G is a view for describing an example of the contact body unit and the vibration body according to the first embodiment.
Fig. 5A is a view illustrating a schematic configuration of a contact body unit according to the first embodiment.
Fig. 5B is a view illustrating a schematic configuration of a contact body unit according to the first embodiment.
Fig. 5C is a view illustrating a schematic configuration of a contact body unit according to the first embodiment.
Fig. 6A is a view illustrating a schematic configuration of a contact body unit and a displacement-detecting portion according to the first embodiment.
Fig. 6B is a view illustrating a schematic configuration of the contact body unit and the displacement-detecting portion according to the first embodiment.
Fig. 6C is a view illustrating a schematic configuration of the contact body unit and the displacement-detecting portion according to the first embodiment.
Fig. 7 is a view illustrating a schematic configuration of a vibration actuator according to the first embodiment.
Fig. 8A is a view for describing a configuration of a vibration body unit of the vibration actuator according to the first embodiment.
Fig. 8B is a view for describing a configuration of the vibration body unit of the vibration actuator according to the first embodiment.
Fig. 8C is a view for describing a configuration of the vibration body unit of the vibration actuator according to the first embodiment.
Fig. 9A is a view illustrating a schematic configuration of another vibration actuator according to the first embodiment.
Fig. 9B is a view illustrating a schematic configuration of the other vibration actuator according to the first embodiment.
Fig. 9C is a view illustrating a schematic configuration of the other vibration actuator according to the first embodiment.
Fig. 10A is a view for describing an example of a contact body unit and a vibration body according to a second embodiment.
Fig. 10B is a view for describing an example of the contact body unit and the vibration body according to the second embodiment.
Fig. 10C is a view for describing an example of the contact body unit and the vibration body according to the second embodiment.
Fig. 10D is a view for describing an example of the contact body unit and the vibration body according to the second embodiment.
Fig. 10E is a view for describing an example of the contact body unit and the vibration body according to the second embodiment.
Fig. 11 is a view illustrating a schematic configuration of a vibration actuator according to the second embodiment.
Fig. 12A is a view illustrating a schematic configuration of another vibration actuator according to the second embodiment.
Fig. 12B is a view illustrating a schematic configuration of the other vibration actuator according to the second embodiment.
Fig. 13A is a view for describing another example of the contact body unit and the vibration body according to the second embodiment.
Fig. 13B is a view for describing another example of the contact body unit and the vibration body according to the second embodiment.
Fig. 13C is a view for describing another example of the contact body unit and the vibration body according to the second embodiment.
Fig. 13D is a view for describing another example of the contact body unit and the vibration body according to the second embodiment.
Fig. 13E is a view for describing another example of the contact body unit and the vibration body according to the second embodiment.
Fig. 13F is a view for describing another example of the contact body unit and the vibration body according to the second embodiment.
Fig. 14 is a view illustrating a state in which a displacement-detecting portion is attached to a vibration body unit according to the second embodiment.
Fig. 15A is a view illustrating a schematic configuration of an actuator unit according to a third embodiment.
Fig. 15B is a view illustrating a schematic configuration of the actuator unit according to the third embodiment.
Fig. 15C is a view illustrating a schematic configuration of the actuator unit according to the third embodiment.
Fig. 15D is a view illustrating a schematic configuration of the actuator unit according to the third embodiment.
Fig. 16A is a view illustrating a schematic configuration of an actuator unit according to a fourth embodiment.
Fig. 16B is a view illustrating a schematic configuration of the actuator unit according to the fourth embodiment.
Fig. 16C is a view illustrating a schematic configuration of the actuator unit according to the fourth embodiment.
Fig. 16D is a view illustrating a schematic configuration of the actuator unit according to the fourth embodiment.
Fig. 17A is a view illustrating a schematic configuration of an actuator unit according to the fourth embodiment.
Fig. 17B is a view illustrating a schematic configuration of the actuator unit according to the fourth embodiment.
Fig. 17C is a view illustrating a schematic configuration of the actuator unit according to the fourth embodiment.
Fig. 18 is a view illustrating a schematic configuration of an apparatus according to a fifth embodiment.
Fig. 19A is a view illustrating a schematic configuration of an apparatus according to a sixth embodiment.
Fig. 19B is a view illustrating a schematic configuration of the apparatus according to the sixth embodiment.
Fig. 20 is a view illustrating a schematic configuration of a multi-axis stage according to a seventh embodiment.
Fig. 21 is a view illustrating a schematic configuration of an articulated robot according to an eighth embodiment.
Fig. 22 is a view illustrating a schematic configuration of an articulated robot according to a ninth embodiment.
Fig. 23 a view illustrating a schematic configuration of a wire-driven manipulator of the articulated robot according to the ninth embodiment.

### DESCRIPTION OF EMBODIMENTS

Hereafter, embodiments of the present invention will be described with reference to the attached drawings.

First, a vibration body and a contact body that are used in common in vibration actuators according to the embodiments described below will be described.

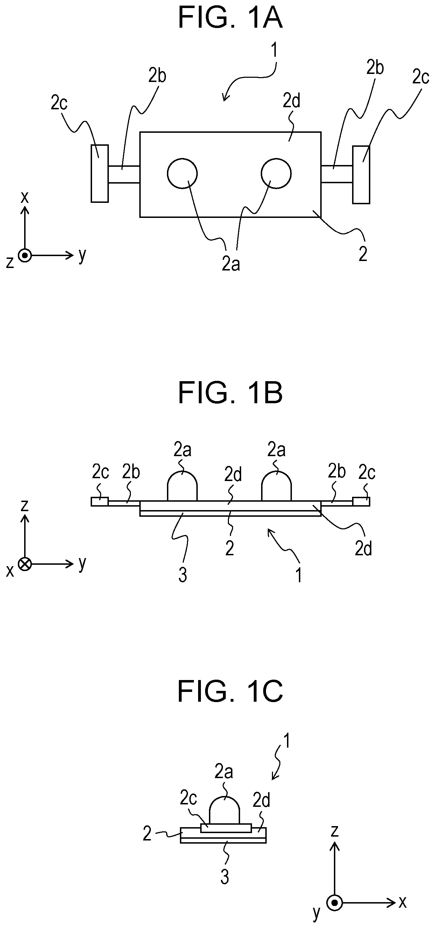

Figs. 1A to 1C are views illustrating schematic configurations of a vibration body 1 of the vibration actuator. Fig. 1A is a plan view of the vibration body 1, Fig. 1B is a front view of the vibration body 1, and Fig. 1C is a side view of the vibration body 1. For convenience of description, as illustrated in Figs. 1A to 1C, an orthogonal coordinate system having an x-axis (x-direction), a y-axis (y-direction), and a z-axis (z-direction) is set for the vibration body 1. The z-direction is the thickness direction of the vibration body 1 and is a protruding direction of projecting portions 2a (described below in detail) that are provided at two positions. The y-direction is the longitudinal direction of the vibration body 1 and is a direction connecting the two projecting portions 2a. The x-direction is the transversal direction (width direction) of the vibration body 1 and is a direction perpendicular to the y-direction and the z-direction. Regarding each direction illustrated in Figs. 1A to 1C, a direction from the start point toward the end point of an arrow indicating the direction is defined as a positive direction (+direction), and a direction from the end point toward the start point is defined as a negative direction (-direction).

The vibration body 1 includes an elastic body 2 and an electric-mechanical energy conversion element 3 joined to the elastic body 2. The electric-mechanical energy conversion element 3 is, for example, a piezoelectric element that converts a voltage to a force by using an inverse piezoelectric effect, and electrodes to which a predetermined voltage is applied are provided on the front and back surfaces of rectangular thin-plate-shaped piezoelectric ceramics. The elastic body 2 includes the projecting portions 2a, suspending support portions 2b, support end portions 2c, and a base portion 2d. The base portion 2d has a rectangular flat-plate-like shape, and the electric-mechanical energy conversion element 3 is joined to the base portion 2d. The two projecting portions 2a are provided on the base portion 2d so as to protrude in the +z-direction from a surface opposite to a surface to which the electric-mechanical energy conversion element 3 is joined. The projecting portions 2a may be formed by press working the elastic body 2 (the base portion 2d) or by joining projecting members to the base portion 2d by using a predetermined method. The suspending support portions 2b are rectangular flat-plate-shaped portions that are provided at both ends of the base portion 2d in the y-direction and that serve to connect the base portion 2d and the support end portions 2c. The support end portions 2c are rectangular flat-plate-shaped portions for fixing the vibration body 1 to a holding portion 8 described below.

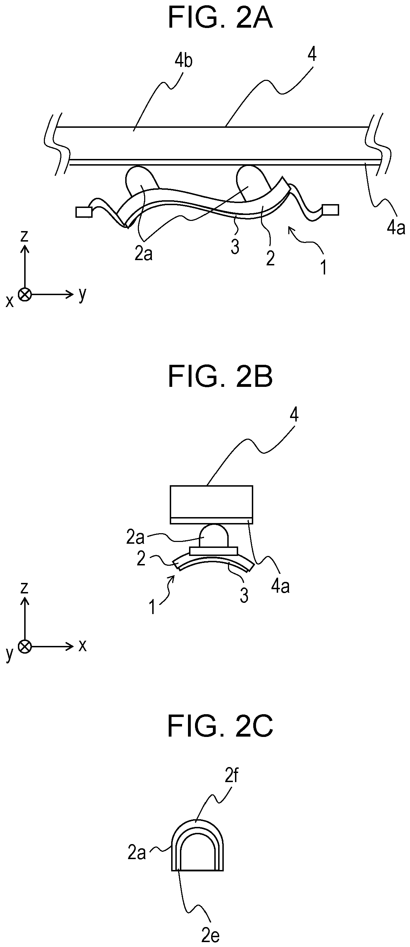

Here, the projecting portion 2a will be described in detail. Fig. 2C is a cross-sectional view illustrating a schematic structure of the projecting portion 2a. A friction material 2f is provided on a surface of a parent material 2e of the projecting portion 2a. Here, the material of the parent material 2e is the same as that of the base portion 2d. When martensitic stainless steel is used for the parent material 2e, it is possible to use electroless nickel plating, chrome plating, a quench-hardened layer, a nitride film formed by ion nitriding treatment, or the like as the friction material 2f. By using a fiber-reinforced engineering plastic such as PEEK-CF30 or hard ceramics as the parent material 2e, it is also possible to use a configuration such that the parent material 2e serves also as the friction material 2f (in this case, there is no distinction between the parent material 2e and the friction material 2f).

Next, referring to Figs. 2A to 2C, two vibration modes (vibration forms) that are excited in the vibration body 1 will be described. Figs. 2A to 2C illustrate the vibration modes excited in the vibration body 1. Fig. 2A is a view for describing a first vibration mode, and Fig. 2B is a view for describing a second vibration mode. In Figs. 2A to 2C, deformation of the vibration body 1 is illustrated with exaggeration. For convenience of description, a contact body 4 that contacts the vibration body 1 and receives thrust (frictional driving force) from the vibration body 1 is illustrated.

The contact body 4 is a member that contacts the projecting portions 2a of the vibration body 1. Due to vibration generated in the vibration body 1, the vibration body 1 and the contact body 4 move relative to each other in the y-direction as described below. Contact between the vibration body 1 and the contact body 4 is not limited to direct contact such that another member is not interposed between the vibration body 1 and the contact body 4. As long as the vibration body 1 and the contact body 4 move relative to each other due to vibration generated in the vibration body 1, contact between the vibration body 1 and the contact body 4 may be indirect contact such that another member is interposed between the vibration body 1 and the contact body 4.

The first vibration mode illustrated in Fig. 2A is a secondary out-of-plane bending vibration mode in which three nodal lines that are substantially parallel to the x-direction are generated in the base portion 2d. Due to the first vibration mode, vibrations that become displaced in the y-direction are generated at end portions of the two projecting portions 2a. The second vibration mode illustrated in Fig. 2B is a primary out-of-plane bending vibration mode in which two nodal lines that are substantially parallel to the y direction are generated in the base portion 2d. Due to the second vibration mode, vibrations that become displaced in the z-direction are generated at the end portions of the two projecting portions 2a.

By simultaneously generating vibration in the first vibration mode and vibration in the second vibration mode by applying a plurality of alternating voltages having different phases to the electric-mechanical energy conversion element 3, it is possible to generate, at the end portions of the two projecting portions 2a, an elliptic motion in the yz-plane in which the vibrations are combined. When the elliptic motion is generated in the yz-plane at the end portions of the two projecting portions 2a, the contact body 4 receives thrust in the y-direction, and, as a result, it is possible to move the vibration body 1 and the contact body 4 relative to each other in the y-direction.

In a state in which a voltage is not applied to the electric-mechanical energy conversion element 3, a static frictional force between the projecting portions 2a and the contact body 4 serves as a holding force for maintaining the relative positions of the vibration body 1 and the contact body 4. Moreover, by adjusting the amplitude of vibration generated in the vibration body 1 by adjusting a voltage applied to the electric-mechanical energy conversion element 3, it is possible to adjust the contact time between the projecting portions 2a and the contact body 4 to change apparent frictional force. Furthermore, by generating only vibration in the second vibration mode in the vibration body 1 and controlling the amplitude of the vibration, it is possible to change a frictional force generated between the projecting portions 2a and the contact body 4. By using these, for example, in a configuration such that the contact body 4 moves relative to the vibration body 1, it is possible to adjust the magnitude of a reaction force when the contact body 4 is moved by applying an external force (a force applied from a source other than the vibration body 1) to the contact body 4. For example, it is possible to adjust an operational reaction force that a user receives when the user performs an operation by directly applying an external force to the contact body 4.

As illustrated in Figs. 2A to 2C, in the vibration actuator using the vibration body 1, the end portions of the two projecting portions 2a contact the contact body 4. A friction material 4a is provided on a surface the contact body 4 that is a contact surface (frictional sliding surface) that contacts the projecting portions 2a. As described above, the friction material 2f is provided on the surface of the projecting portions 2a. Thus, it is possible to obtain stable frictional sliding characteristics between the vibration body 1 and the contact body 4. The material of the friction material 4a and a method of forming the friction material 4a may be similar to those of the friction material 2f.

Next, materials used for the vibration body 1 and the contact body 4 will be described. Examples of the material of the elastic body 2 of the vibration body 1 include martensitic stainless steel whose vibration loss is small and high-toughness ceramics such as partially-stabilized zirconia (PSZ). Other examples the material include engineering plastics (FRP) such as polyether ether ketone (PEEK-CF30) reinforced by carbon fiber of about 30 wt%, semiconductors such as silicon carbide (SiC), and aluminum alloys. Examples of the material of the electric-mechanical energy conversion element 3 of the vibration body 1 include piezoelectric ceramics such as lead zirconate titanate (PZT). Examples of the material of the contact body 4 include martensitic stainless steel, aluminum alloys, FRP such as PEEK-CF30, and fine ceramics such as PSZ or alumina (aluminum oxide). The materials of the vibration body 1 and the contact body 4 are not limited to those listed here.

### First Embodiment.

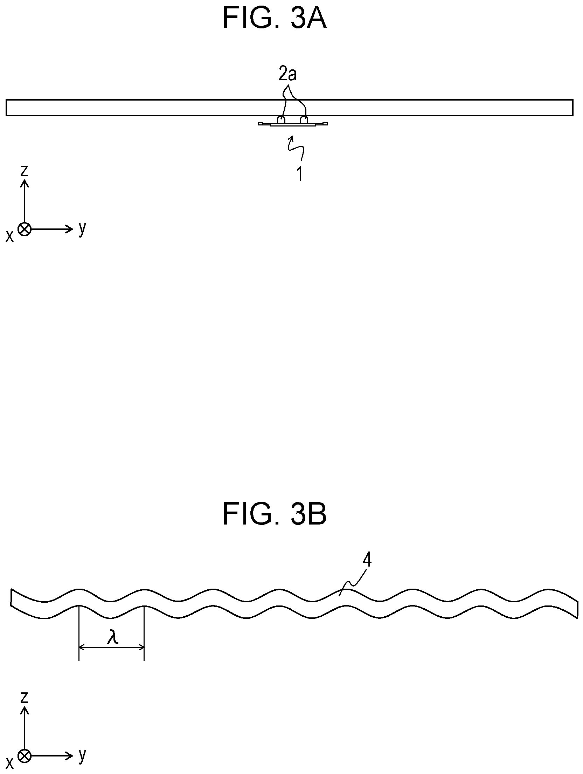

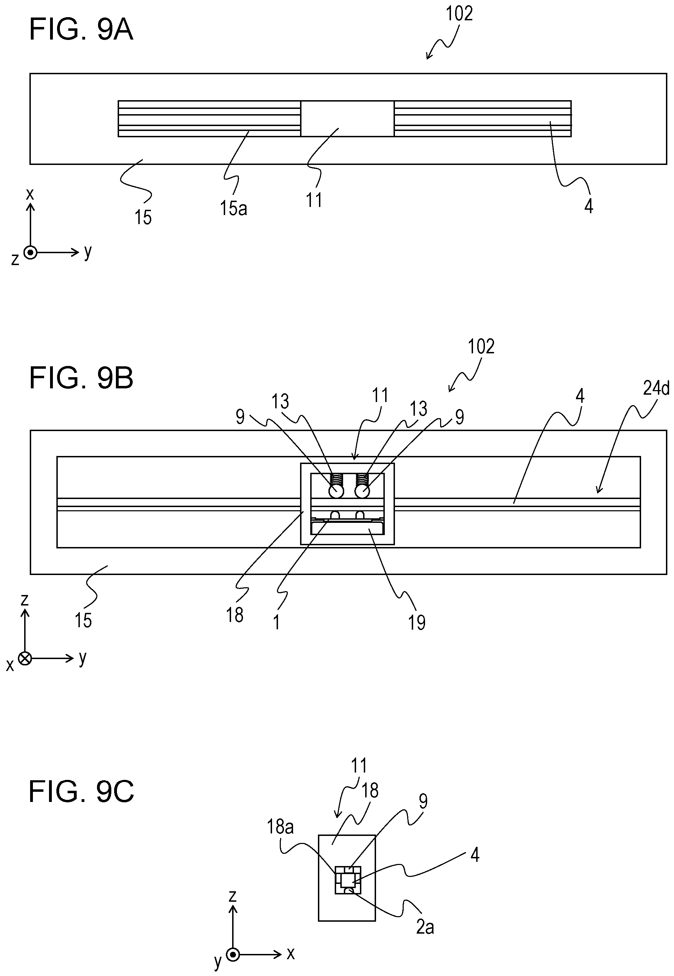

Referring to Figs. 3A to 9C, a first embodiment will be described.

Figs. 3A to 3D are views for describing the vibration actuator according to the first embodiment, and schematically illustrate the vibration body 1 and the contact body 4.

Fig. 3A is a front view of the contact body 4 and one vibration body 1 pressed against (in pressed contact with) the contact body 4. In accordance with the x-direction, the y-direction, and the z-direction that are set for the vibration body 1, an x-direction, a y-direction, and a z-direction are set as illustrated in Figs. 3A to 3D. Including vibration actuators according to other embodiments described below, the y-direction is defined as the left-right direction of the vibration actuator, the +y side is defined as the right side, and the -y side is defined as the left side. The z-direction is the up-down direction of the vibration actuator, the +z side is defined as the upper side, and the -z side is defined as the lower side. Exemplary configurations for pressing the vibration body 1 against the contact body 4 will be described below.

Fig. 3B is a front view of the contact body 4, illustrating, with exaggeration, the vibration form of an out-of-plane bending mode generated in the contact body 4. When the first vibration mode, the second vibration mode, or both of these is/are excited with a predetermined drive frequency in the vibration body 1, a natural vibration mode is excited in the contact body 4 if the drive frequency is close to the natural frequency of the natural vibration mode of the contact body 4. For example, when an out-of-plane vibration mode that vibrates in the z-direction at a wavelength λ with respect to a plane parallel to the xy-plane as illustrated in Fig. 3B is excited in the contact body 4, the projections 2a of the vibration body 1 and the contact body 4 intermittently repeat a contact state and a non-contact state. Thus, contact between the projections 2a and the contact body 4 becomes unstable, and, in addition, beating noise is generated and thrust decreases. Moreover, the difference between a drive frequency exited in the vibration body 1 and the natural frequency of the natural vibration mode of the contact body 4 generates noise, and thrust may decrease.

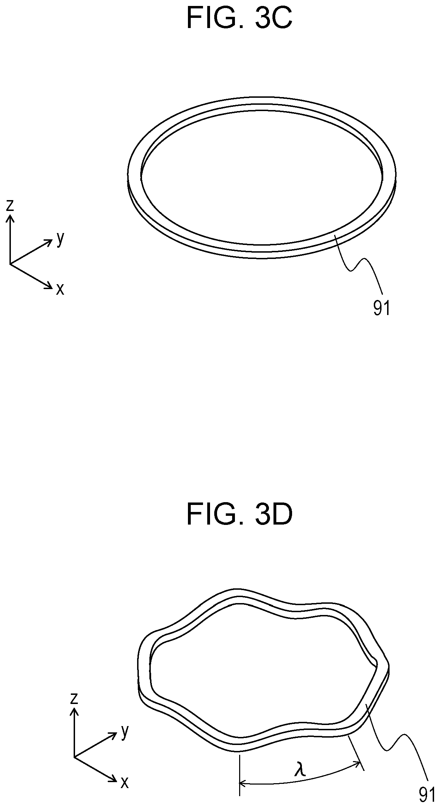

This unnecessary vibration is generated not only in the contact body 4 having a bar-like shape as illustrated in Figs. 3A and 3B. For example, the same applies to a contact body 91 having an annular shape as illustrated in Figs. 3C and 3D. Specific exemplary configurations of a vibration actuator using the annular contact body 91 will be described in detail in the following embodiments. Fig. 3D is a perspective view of the contact body 91 in which an out-of-plane bending mode generated in the contact body 91 is illustrated with exaggeration. Also in this case, when vibration is exited in the vibration body 1, a natural vibration mode is excited in the contact body 91 if the drive frequency of the vibration is close to the natural frequency of the natural vibration mode of the contact body 91. For example, as illustrated in Fig. 3D, when an out-of-plane vibration mode that vibrates in the z-direction at a wavelength λ with respect to a plane parallel to the xy-plane is excited in the contact body 91 and the shape of the contact body 91 is close to a circular shape, the excited out-of-plane vibration forms a progressive wave to become an amplified unnecessary vibration, and causes decrease in performance due to similar unnecessary vibration.

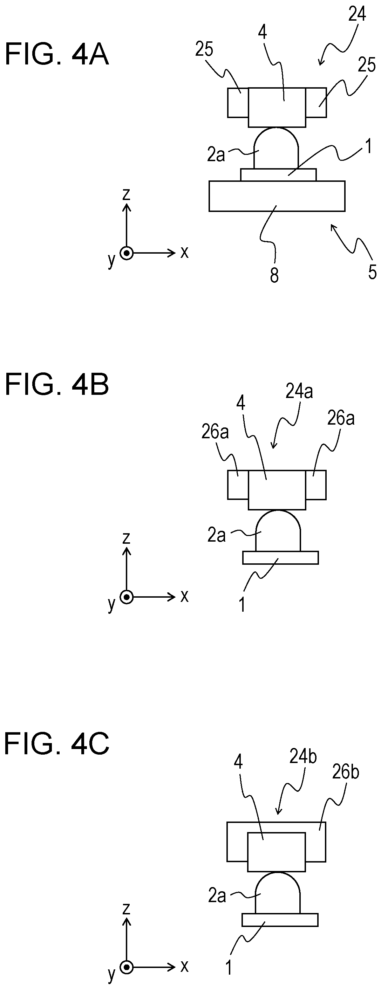

Hereafter, referring to Figs. 4A to 6C, measures to suppress unnecessary vibration generated in the contact body 4 in the first embodiment will be described.

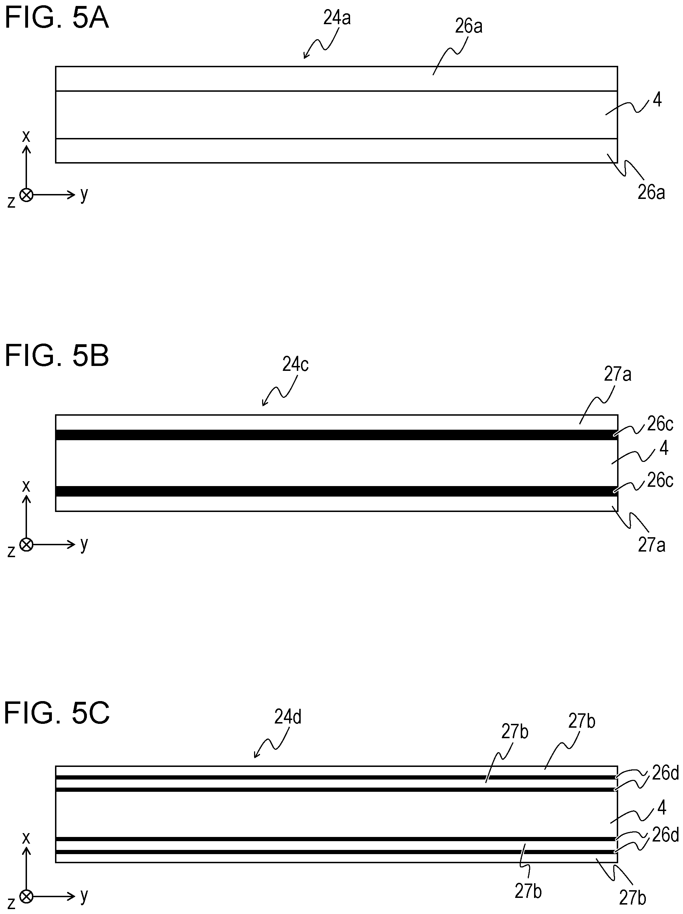

Figs. 4A to 4G are right-side views for describing examples of a contact body unit and the vibration body 1 pressed against the contact body unit. Figs. 5A to 5C are bottom views illustrating schematic configurations of some of the contact body units illustrated in Figs. 4A to 4G.

Fig. 4A is a view illustrating the basic configuration of a contact body unit according to the first embodiment, which is a configuration such that one vibration body 1 is pressed against the contact body 4 of a contact body unit 24. The contact body unit 24 is configured by joining a vibration-damping member 25 to a predetermined surface of the contact body 4 that is different from the contact surface, which is both side surfaces of the contact body 4 in the x-direction here. In this way, the vibration-damping member 25 is provided on both of the side surfaces of the contact body 4 in the x-direction that are connected to the contact surface and face each other. A lower end of each of the vibration-damping members 25 is configured to be located above a lower end of the contact body 4, that is, the contact surface in the z-direction. With the shape such that an end portion of the vibration-damping member 25 does not protrude further than the contact surface in this way, it is easy to grind (polish) the contact surface to improve smoothness and surface roughness even after the contact body unit 24 has been assembled. As described below in detail, the vibration-damping member 25 is constituted by a viscoelastic body or by a combination of a viscoelastic body and a reinforcement member.

Figs. 4B to 4G are views for describing exemplary configurations of the vibration-damping member, illustrating configurations such that one vibration body 1 is pressed against the contact body 4 of the contact body unit.

Fig. 4B is a view illustrating a contact body unit 24a, which is an example in which the vibration-damping member includes only a viscoelastic body 26a. Fig. 5A is a bottom view of the contact body unit 24a. In the contact body unit 24a, the viscoelastic body 26a is joined to both side surfaces of the contact body 4 in the x-direction. It is assumed that the mechanical quality factor Q of the viscoelastic body 26a is lower than that of the contact body 4. As the material of the viscoelastic body 26a, a material having both of viscosity and elasticity such as rubber or resin is suitable. As a rubber material, butadiene rubber, butyl rubber, silicon rubber, or the like having high vibration-damping performance is suitable. When the viscoelastic body 26a is joined to the contact body 4, internal strain is generated in the viscoelastic body 26a in accordance with strain of the joining surface generated in accordance with deformation of the contact body 4 in a natural vibration mode excited in the contact body 4 as unnecessary vibration. By using this, it is possible to cause the viscoelastic body to absorb vibration energy and to reduce the vibration amplitude of unnecessary vibration generated in the contact body 4.

Fig. 4C is a view illustrating a contact body unit 24b, which is an example in which the vibration-damping member includes only a viscoelastic body 26b that is joined also to a back surface of the contact body 4, which is a surface opposite to the contact surface. A bottom view, which is similar to Fig. 5A, is omitted. In the contact body unit 24b, the viscoelastic body 26b is joined to three surfaces (both side surfaces in the x-direction and the back surface) of the contact body 4 by fitting the contact body 4 into a groove portion in the viscoelastic body 26b having a recessed cross-sectional shape. As described above, rubber or resin is suitable as the material the viscoelastic body 26b. For example, the contact body unit 24b may be configured by using a resin material having a large attenuation coefficient and by fitting the contact body 4 and viscoelastic body to each other. By joining the viscoelastic body 26b to the three surfaces of the contact body 4, it is possible to increase region for absorbing vibration energy in accordance with strain generated in accordance with deformation of the contact body 4 and to increase the effect of suppressing unnecessary vibration compared with the contact body unit 24a.

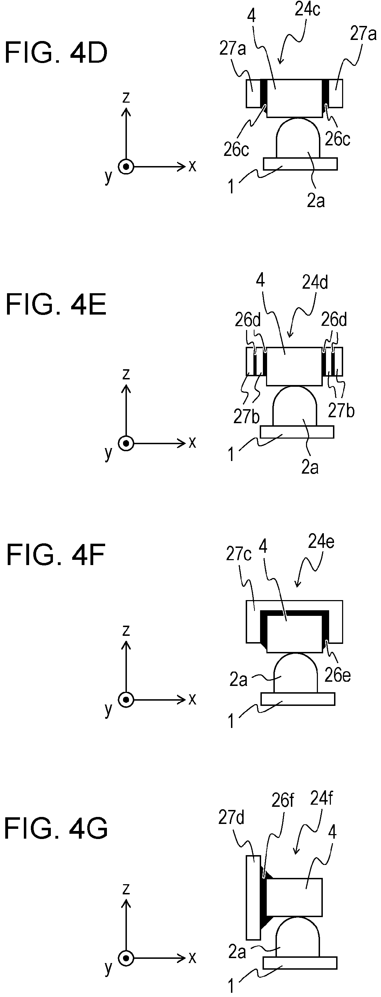

Fig. 4D is a view illustrating a contact body unit 24c, which is an example in which the vibration-damping member includes a combination of a viscoelastic body 26c and a reinforcement member 27a. Fig. 5B is a bottom view of the contact body unit 24c. In the contact body unit 24c, the viscoelastic body 26c is joined to both side surfaces of the contact body 4 in the x-direction, and the reinforcement member 27a is joined to the viscoelastic body 26c. In this way, the viscoelastic body 26c is interposed between the contact body 4 and the reinforcement member 27a. As described above, rubber or resin is suitable as the material of the viscoelastic body 26c, and a double-sided tape or an adhesive may be used additionally. It is assumed that the mechanical quality factor Q of the viscoelastic body 26c is lower than that of each of the contact body 4 and the reinforcement member 27a. As the material of the reinforcement member 27a, a material whose elastic modulus is sufficiently higher than that of the viscoelastic body 26c is suitable. For example, various metals, ceramics, engineering plastic, and the like are usable, and the material may be the same as that of the contact body 4. When the reinforcement member 27a is joined to the contact body 4 via the viscoelastic body 26c, both side surfaces of the viscoelastic body 26c are joined to the contact body 4 and the reinforcement member 27a. Since the displacement distribution of the viscoelastic body 26c is restrained at the joint surface with the reinforcement member 27a having a larger elastic modulus, it is possible to absorb vibration energy by generating shearing strain of the viscoelastic body 26c due to deformation of the contact body 4 and to reduce the vibration amplitude of unnecessary vibration generated in the contact body 4.

Fig. 4E is a view illustrating a contact body unit 24d, which is an example in which the vibration-damping member has a multilayer structure in which a plurality of viscoelastic bodies 26d and a plurality of reinforcement members 27b are alternately arranged. Fig. 5C is a bottom view of the contact body unit 24d. In the contact body unit 24d, a viscoelastic body 26d and a reinforcement member 27b are joined from both sides of the contact body 4 in the x-direction and another set of a viscoelastic body 26d and a reinforcement member 27b are further joined. The materials of the viscoelastic body 26d and the reinforcement member 27b are similar to those described with reference to Fig. 4D. When the vibration-damping member has a multilayer structure in which the plurality of the viscoelastic bodies 26d and the plurality of the reinforcement members 27b are alternately arranged, it is possible to increase vibration energy to be absorbed by generating shearing strain. Thus, it is possible to more effectively reduce the vibration amplitude of unnecessary vibration generated in the contact body 4. Moreover, compared a case of the contact body unit 24c, it is possible to reduce the thickness of the viscoelastic body 26d in the x-direction. By reducing the thickness of the viscoelastic body 26d, it is possible to reduce displacement of the vibration-damping member in the xy-plane when an external force is applied to the contact body unit 24d via the reinforcement member 27b. Accordingly, in a case where a linear guide that linearly guides the contact body unit 24d is configured by supporting the reinforcement member 27b that is exposed on a side surface, it is possible to improve the rigidity of the linear guide, compared with a case of the contact body unit 24c. Thus, it is possible to position the contact body 4 with high precision.

Fig. 4F is a view illustrating a contact body unit 24e, which is an example in which the vibration-damping member includes a combination of a viscoelastic body 26e and a reinforcement member 27c and is joined also to the back surface of the contact body 4. A bottom view, which is similar to Fig. 5B, is omitted. In the contact body unit 24e, the viscoelastic body 26e is joined to three surfaces (both side surfaces in the x-direction and the back surface) of the contact body 4 by fitting the contact body 4 into a groove portion of the viscoelastic body 26e having a recessed cross-sectional shape. Moreover, the reinforcement member 27c is joined to three surfaces (both side surfaces in the x-direction and the back surface) of the viscoelastic body 26e by fitting the viscoelastic body 26e into a groove portion of the reinforcement member 27c having a recessed cross-sectional shape. That is, this is an example of a combination of the configuration of the contact body unit 24b illustrated in Fig. 4C and the configuration of the contact body unit 24c illustrated in Fig. 4D. The materials of the viscoelastic body 26e and the reinforcement member 27c are similar to those described with reference to Fig. 4D. Advantageous effects due to this configuration are also similar to those described with reference to Fig. 4C and Fig. 4D.

Fig. 4G is a view illustrating a contact body unit 24f, which is an example in which the vibration-damping member includes a combination of a viscoelastic body 26f and a reinforcement member 27d. In the contact body unit 24f, the viscoelastic body 26f is joined to one side surface of the contact body 4 in the x-direction (the left side surface in the illustrated example), and the reinforcement member 27d is joined to the viscoelastic body 26f. Here, an adhesive is used as the viscoelastic body 26f, and due to the wettability of the adhesive, the viscoelastic body 26f spreads to two flat surfaces (the contact surface and the back surface) of the contact body 4 that are parallel to the xy-plane. In this case, the amount of the adhesive to become the viscoelastic body 26f is controlled so that the adhesive may not contact the projection 2a of the vibration body 1. The reinforcement member 27d has a length in the z-direction that exceeds the thickness of the contact body 4 so as to receive the adhesive. In this way, end portions of the vibration-damping member (end portions of the viscoelastic body 26f, end portions of the reinforcement member 27d) protrude further than the contact surface and the back surface. The material of the reinforcement member 27d is similar to that described regarding the contact body unit 24c with reference to Fig. 4D. Also with the contact body unit 24f, it is possible to obtain the advantageous effect of suppressing unnecessary vibration by absorbing excitation energy by using shearing strain of the viscoelastic body 26f. Since the viscoelastic body 26f spreads to two flat surfaces of the contact body parallel to the xy-plane, the adhesive strength of the reinforcement member 27d is increased, and absorption of excitation energy is performed as internal strain is generated in the viscoelastic body that has spread. Thus, it is possible to reduce the vibration amplitude of unnecessary vibration generated in the contact body 4.

In the following description, various contact body units and vibration-damping members (viscoelastic bodies, reinforcement members) described with reference to Figs. 4A to 4G may be referred to as the contact body unit 24, the vibration-damping member 25, the viscoelastic body 26, and the reinforcement member 27 by using representative numerals. It is also possible to provide the vibration-damping member 25 with a function other than suppression of unnecessary vibration.

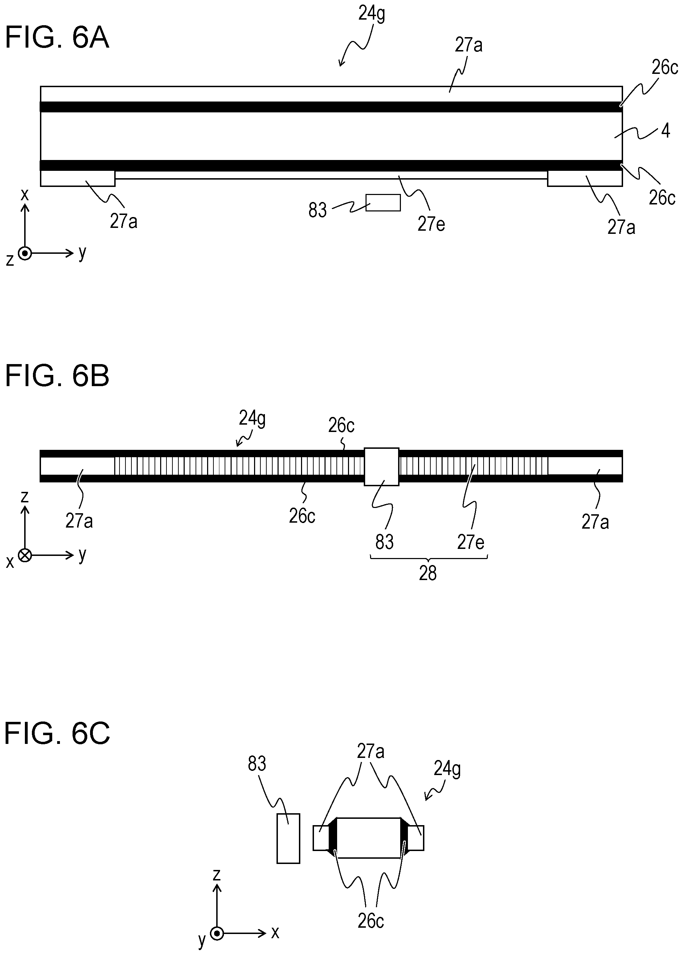

Referring to Figs. 6A to 6C, an exemplary configuration such that the vibration-damping member 25 is provided with a displacement-detection function of detecting relative displacement of the vibration body 1 and the contact body 4 will be described. Figs. 6A, 6B, and 6C are respectively a plan view, a front view, and a right-side view illustrating the positional relationship between a contact body unit 24g and a detector 83. In the contact body unit 24g, the viscoelastic body 26c is joined to both side surfaces of the contact body 4 in the x-direction, the reinforcement member 27a is joined to the viscoelastic body 26c, and a part of the reinforcement member 27a is replaced with a scale 27e. As illustrated in Fig. 6B, the scale 27e is a reflective diffraction grating and has a pattern of reflective portions and non-reflective portions formed by removing a metal film, deposited on a glass surface, by etching or laser processing. In this case, the scale 27e is joined to the viscoelastic body 26c, and thus constrains a side surface of the viscoelastic body 26c and functions as a reinforcement member. In this way, a part of the vibration-damping member 25 constitutes the scale 27e. The detector 83 is set at a position that is separated by a gap from the scale 27e in the x-direction and that does not physically interfere with the scale 27e. The detector 83 includes a light source and a light receiver, and can read the scale 27e by emitting light from the light source to the scale 27e and receiving reflection of the light with the light receiver. In this way, the detector 83 and the scale 27e constitute a displacement-detecting portion 28 and functions as a linear encoder that detects displacement in the y-direction. In this way, the scale 27e can have the effects and the functions of both of the vibration-damping member 25 and the displacement-detecting portion 28. By affixing the scale 27e via the viscoelastic body 26c, the viscoelastic body 26c serves as a vibration insulator that makes it difficult for vibration of the contact body 4 to be transmitted the scale 27e, and thus it is possible to reduce displacement detection error due to vibration of the scale 27e.

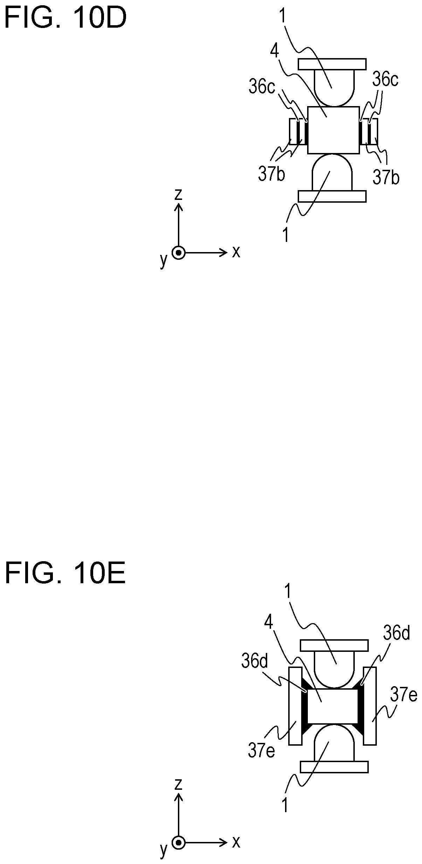

Although the dimension of the scale 27e in the z-direction is illustrated to be less than that of the contact body 4 in Figs. 6A to 6C, as described above with reference to Fig. 4G, the scale 27e may be configured to overhang toward the contact surface side of the contact body 4. When the scale 27e overhangs, the area of the viscoelastic body 26 is increased, and it is possible to further increase the vibration-damping effect. As described below with reference to Fig. 10E, by affixing reinforcement members to both side surfaces of the contact body and by providing at least one of them with a function of a scale, it is possible to expect a dustproof effect of reducing the amount of abrasion powder that is generated by frictional driving and scattered to the outside from the vicinity of the contact surface. As described above, by causing the viscoelastic body to protrude toward the contact surface side of the contact body and providing the viscoelastic body with adhesion, it is possible to trap abrasion powder generated by frictional driving and to increase the dustproof effect.

Although glass is used as the material of the scale 27e, it is also possible to use a metal. Regarding a method of forming the reflective portions and the non-reflective portions, it is also possible to use another method such as electroforming or printing. Although the scale 27e and the reinforcement member 27a are illustrated as independent bodies in Figs. 6A to 6C, a film-shaped scale may be affixed to a side surface of the reinforcement member. It may be possible to form a scale by performing vapor deposition or printing on a side surface of the viscoelastic body. Although an exemplary configuration such that a scale is affixed to a side surface of the contact body via a viscoelastic body has been described above, this is not a limitation. For example, the contact body may be formed from a metal, protruding/recessed shapes may be formed on a side surface of the contact body by etching or electroforming, and a viscoelastic body may be injected into recessed portions. As a shape such that the viscoelastic body is disposed in the recessed portion is periodically repeated in the y-direction, the protruding portions serve as reflective portions and the viscoelastic body injected into the recessed portions serve as non-reflective portions. Thus, a function equivalent to that of a scale is realized, and it can be expected that the injected viscoelastic body suppresses unnecessary vibration in the same way as described above.

The contact body units 24 described with reference to Figs. 4A to 6C are examples in which the vibration-damping member 25 is joined to the contact body 4 over the entire area in the y-direction. However, this is not a limitation, and the vibration-damping member 25 may be joined to the contact body 4 in a part in the y-direction. Although providing the vibration-damping member 25 over the entire area in the y-direction is effective in suppression of unnecessary vibration, providing the vibration-damping member 25 in a part in the y-direction makes it possible to achieve reduction in size, weight, and space, prevention of interference with other components, cost reduction, and the like. When the vibration-damping member 25 is to be provided in a part in the y-direction, determining the length of the vibration-damping member 25 in the y-direction and the position of the vibration-damping member 25 under the following criteria is effective in view of suppression of unnecessary vibration. A first criterion is that the sum total of the length of the vibration-damping member 25 in the y-direction is greater than or equal to 1/2 of the wavelength of a natural vibration mode excited in the contact body 4 (greater than or equal to 1/2λ in Figs. 3A to 3D). A second criterion is that the sum total of the length of the vibration-damping member 25 in the y-direction is greater than or equal to the length of the interval between adjacent nodal lines of a vibration mode excited in the vibration body 1. A third criterion is that the sum total of the length of the vibration-damping member 25 in the y-direction is greater than or equal to the center-to-center distance between the projections 2a of the elastic body 2. A fourth criterion is that the vibration-damping member 25 is provided at a position including an antinode of a natural vibration mode excited in the contact body 4.

As described above, by providing the vibration-damping member 25 on a side surface of the contact body 4, it is possible to suppress unnecessary vibration generated in the vibration actuator and to prevent output power (thrust) per volume or per weight from becoming small.

Although the width of the contact body unit 24 in the x-direction is illustrated to be greater than the width of the vibration body 1 and less than the width of the holding portion 8 in Figs. 4A to 4G, this is not a limitation. By appropriately designing and selecting the shape and the material of the viscoelastic body 26 and the reinforcement member 27 of the vibration-damping member 25, it is also possible to further reduce the width dimension of the contact body unit 24 and to set the width dimension to be, for example, less than the width dimension of the vibration body 1. In this way, it is possible to reduce the size of the vibration actuator.

Although an out-of-plane bending vibration mode generated in the contact bodies 4 and 91 has been described as an example in Figs. 3B and 3D, the present invention is effective for another natural vibration mode such as an in-plane vibration mode, a torsional vibration mode, or the like. Also for vibration such as in-plane vibration and torsional vibration, it is possible to suppress the vibration in the same way as for out-of-plane vibration by providing the vibration-damping member 25 so as to include an antinode with large strain. Moreover, by appropriately changing the disposition of the vibration-damping member 25 and the configuration of the vibration-damping member 25, it is possible to suppress unnecessary vibration due to any vibration mode, for a plurality of vibration modes whose positions of portions (antinodes) where strain of the vibration mode is large differ.

Heretofore, examples of the way of setting the vibration-damping member 25 have been described. In Figs. 4A to 6C, the viscoelastic body 26 does not cover an end portion of the contact body 4 including a surface parallel to the xz-plane. Even when the viscoelastic body 26 covers the end portion of the contact body 4, the effect of suppressing unnecessary vibration is not likely to decrease, and such a configuration is not beyond the scope of the present invention. However, since only a small effect of suppressing unnecessary vibration is obtained by covering a surface parallel to the xz-plane where strain is not generated with respect to unnecessary vibration of the contact body 4, examples in each of which the vibration-damping member is joined to a side surface of the contact body 4 have been described in the present embodiment.

In a case where the contact surface of the contact body 4 is to be protruded with respect to the vibration-damping member 25 or the vibration-damping member 25 is to be provided at a position of an antinode of a specific natural vibration mode, it is necessary to assemble the contact body unit 24 after determining the relative positions of the contact body 4 and the vibration-damping member 25 with high precision. In such a case, it is possible to efficiently assemble the contact body unit 24 by providing the vibration-damping member 25 and the contact body 4 with a positioning structure such as a positioning pin, a parallel key, any other protruding/recessed shape or mark, or the like.

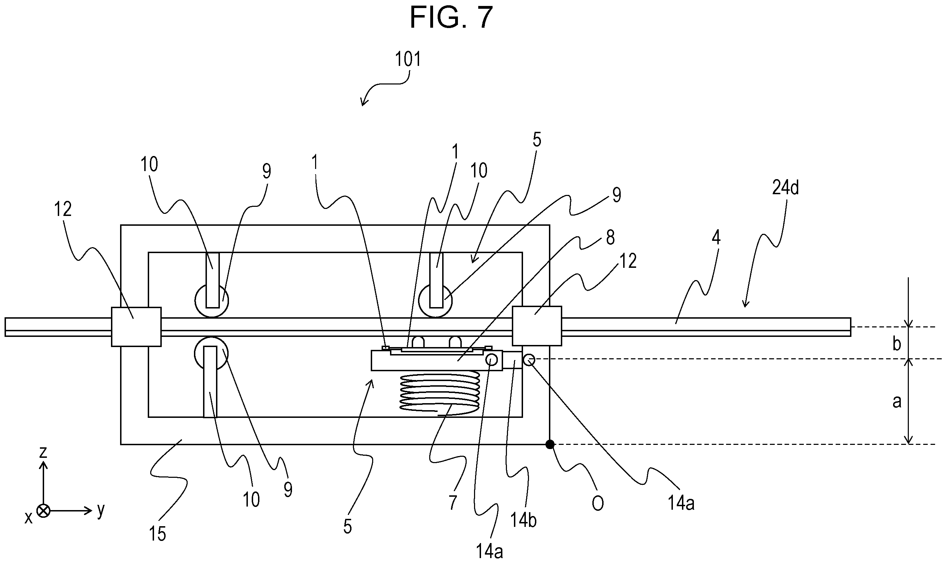

Next, referring to Figs. 7 to 9C, examples of a support structure of the vibration body 1 and the contact body 4 in the first embodiment will be described.

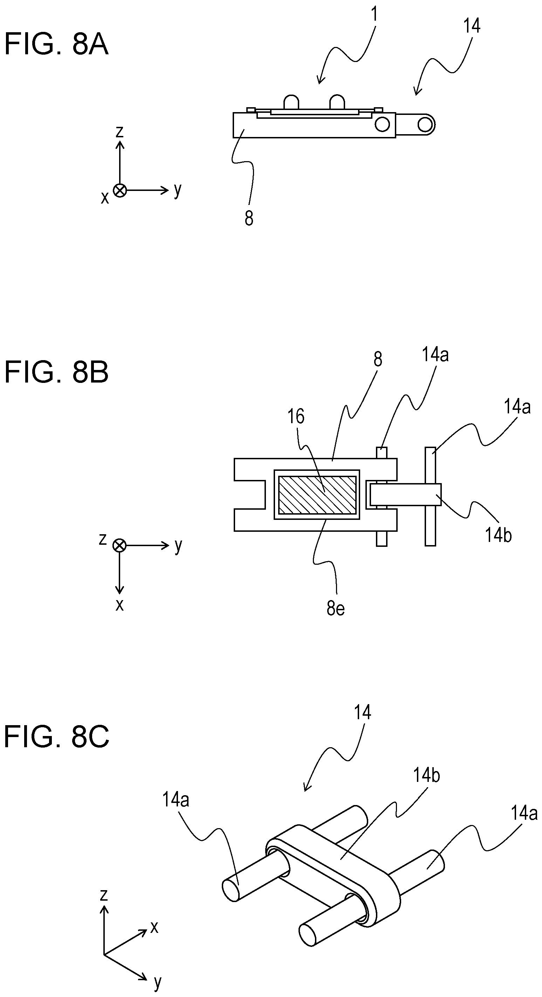

Fig. 7 is a front view illustrating a schematic configuration of a vibration actuator 101 according to the first embodiment. Figs. 8A to 8C are views for describing configurations of a vibration body unit 5 of the vibration actuator 101 according to the first embodiment.

The vibration actuator 101 includes one vibration body unit 5 and the contact body 4 that contacts the vibration body 1 of the vibration body unit 5. Here, the contact body unit 24d described above (referred to as the contact body 4 in the following description) is used in order to suppress unnecessary vibration generated in the contact body 4. Various components of the vibration actuator 101 are assembled on a support member 15 that is a base member.

The vibration body unit 5 includes the vibration body 1, a nonwoven cloth 16, a pressing portion 7, the holding portion 8, a reaction-force receiving portion 9, and a rotation support portion 10. The vibration body unit 5 has a pressing support structure that can excite vibration in the vibration mode described with reference to Figs. 2A to 2C. In one vibration body unit 5, the support end portions 2c of the elastic body 2 are fixed to an upper surface of a wall portion on the y-direction side, which is a side wall of the holding portion 8.

The nonwoven cloth 16 is disposed on the back surface side (a surface opposite to a surface joined to the elastic body 2) of the electric-mechanical energy conversion element 3. The nonwoven cloth 16 is a cloth-like member made of a nonwoven cloth material such as wool felt, glass wool, or the like, and supports the vibration body 1 while maintaining a vibration mode generated in the vibration body 1. As the pressing portion 7 presses the vibration body 1 against the contact body 4 via the nonwoven cloth 16, the projecting portions 2a of the vibration body 1 contact the contact body 4. The vibration body 1 is fixed to the holding portion 8, and the holding portion 8, integrated with the vibration body 1, is pressed toward the contact body 4.

Here, setting of the nonwoven cloth 16 will be described. Fig. 8A is a front view of a main part of the vibration body unit 5, and Fig. 8B is a bottom view corresponding to Fig. 8A. In the holding portion 8, a through-hole 8e extending therethrough in the z-direction is provided, and the electric-mechanical energy conversion element 3 is in a state of being exposed from the through-hole 8e when the holding portion 8 is seen from the -z-direction side in a state in which the vibration body 1 is held by the holding portion 8. The nonwoven cloth 16 (the hatched region in Fig. 8B) is set inside of the through-hole 8e so as to be in contact with the electric-mechanical energy conversion element 3. In practice, a flexible wiring board (not shown) for supplying electric power to the electric-mechanical energy conversion element 3 is attached to the back surface (surface on the -z-direction side) of the electric-mechanical energy conversion element 3. Thus, to be precise, the nonwoven cloth 16 is set so as to be in contact with the flexible wiring board attached to the electric-mechanical energy conversion element 3.

The pressing portion 7 presses the projecting portions 2a of the vibration body 1 against the contact body 4 via the nonwoven cloth 16 with a predetermined pressing force. The pressing portion 7 includes an elastic component having an elastic force such as a coil spring, a plate spring, a coned disc spring, a wave washer, rubber, an air tube, or the like that exhibits a restoring force in the z-direction. It is also possible to configure a pressing portion that uses a magnetic force instead of an elastic force, and a magnet or the like can be used in this case. In the present embodiment, a compression coil spring is used as the pressing portion 7.

The reaction-force receiving portion 9 is disposed so as to contact the back surface (a surface opposite to the contact surface) of the contact body 4, and receives a reaction force of a pressing force that presses the projecting portions 2a of the vibration body 1 against the contact body 4. Two reaction-force receiving portions 9 that face each other are provided in the negative y-axis direction with respect to the vibration body unit 5, and thus three reaction-force receiving portions 9 and one vibration body unit 5 support the contact body 4 in the z-direction. In the vibration actuator 101, each of the reaction-force receiving portions 9 includes a roller that is supported by the rotation support portion 10, which is attached to the support member 15, so as to be rotatable around an axis parallel to the x-axis.

Regarding the vibration actuator 101, it is assumed that the support member 15 is fixed a frame or the like of an apparatus in which the vibration actuator 101 is mounted, and that the contact body 4 moves in the y-direction relative to the support member 15 (the vibration body unit 5) whose position does not change in the apparatus.

The contact body 4 is supported by the support member 15 in a state of being movable in the y-direction due to thrust that the contact body 4 receives from the vibration body 1 included in the vibration body unit 5. To be specific, in the support member 15, four rollers that are rotatable around axes parallel to z-axis are provided as contact-body support portions 12 that movably support the contact body 4. The four contact-body support portions 12 function as a linear guide that allows the contact body 4 to move in the y-direction in a state in which the degree of freedom of the contact body 4 in the x-direction is constrained.

The holding portion 8 of the vibration body unit 5 is attached to the support member 15 via a coupling portion 14. Fig. 8C is a perspective view illustrating a schematic configuration of the coupling portion 14. The coupling portion 14 includes a link member 14b (linking portion) in which two holes are formed at a predetermined interval so as to extend therethrough in the x-direction and cylindrical pins 14a (shaft) that are respectively inserted into the two holes of the link member 14b and substantially parallelly attached to the link member 14b. Two pins 14a are fixed to the link member 14b in the respective holes of the link member 14b. The two pins 14a and the link member 14b may be integrally (seamlessly) formed in an H-shape as seen from the z-direction.

One of the two pins 14a is positioned at a position that is separated by a distance a in the +z-direction from a reference origin O of the support member 15 illustrated in Figs. 4A to 4G, and thus the coupling portion 14 has a degree of rotational freedom around a central axis of the pin 14a positioned with respect to the support member 15. On the other hand, the center of the contact body 4 is positioned at a position that is separated by a distance b in the +z-direction from the center of the pin 14a positioned with respect to the support member 15. In this way, the contact body 4 is positioned, with high precision, at a position that is separated by a distance a + b from the reference origin O of the support member 15 in the +z-direction. With the configuration described above, it is possible for the vibration body unit 5 to slide in the z-direction, and it is possible to press the vibration body unit 5 against the contact body 4 as the vibration body unit 5 conforms to the shape of the contact body 4 even if the contact body 4 has a shape having undulation in the yz-plane due to a manufacturing error or the like.

Figs. 9A to 9C are views illustrating schematic configurations of another vibration actuator 102 according to the first embodiment. Fig. 9A is a plan view of the vibration actuator 102, and Fig. 9B is a front view of the vibration actuator 102.

The vibration actuator 102 includes one vibration body unit 11 and the contact body 4 that contacts the vibration body 1 of the vibration body unit 11, the contact body 4 is fixed to the support member 15, and the vibration body 1 performs relative movement. Here, the contact body unit 24d described above (referred to as the contact body 4 in the following description) is used in order to suppress unnecessary vibration generated in the contact body 4. Constituent elements of the vibration actuator 102 that correspond to those of the vibration actuator 101 (see Fig. 7) will be denoted by the same names and numerals, and descriptions of common configurations and functions will be omitted.

In the vibration actuator 102, both ends of the contact body 4 are fixed to the support member 15. The vibration body unit 11 includes a holding portion 18 in which the holding portion 8, a pressing portion 13, the reaction-force receiving portion 9, and the rotation support portion 10 are integrated as a unit. In the vibration body unit 11, a spacer 19 to which the nonwoven cloth 16 is affixed is disposed inside of the holding portion 18. In a state in which the nonwoven cloth 16 is in contact with the electric-mechanical energy conversion element 3 of the vibration body 1, the support end portions 2c at ends of the vibration body 1 in the y-direction are fixed to the holding portion 18. Fig. 9C is a right-side view illustrating a schematic configuration for describing the supporting relationship between the vibration body unit 11 and the contact body 4. An opening 18a is formed in the holding portion 18. The dimension of the opening 18a in the x-direction is set to be greater than the width dimension of the contact body 4 in the x-direction, and, since an appropriate gap is provided, the opening 18a functions as a linear guide that allows the vibration body unit 11 to move in the y-direction.

The reaction-force receiving portion 9 is provided opposite to the contact surface between the contact body 4 and the projecting portions 2a (above (on the +z side of) the contact body 4), and receives a reaction force of a force that presses the vibration body 1 (the projecting portions 2a) against the contact body 4. The reaction-force receiving portion 9 is supported by a rotation support portion 10 (not shown) equivalent to the rotation support portion 10 of the vibration actuator 101 so as to be rotatable around an axis parallel to the x-axis, and a compression coil spring is disposed as the pressing portion 13 for the rotation support portion 10. In this way, due to a pressing reaction force of the pressing portion 13 (a force with which the compression coil spring is to extend in the z-direction), the reaction-force receiving portion 9 is pressed against the contact body 4 and the end portions of the two projecting portions 2a of the vibration body 1 are pressed against the contact body 4.

With the vibration actuator 102, it is possible for the vibration body unit 11 to move in the y-direction. By forming an opening 15a in the support member 15 as illustrated in Fig. 9A, it is possible to expose the upper surface of the vibration body unit 11 to the outside, and it is possible to connect an object to be driven to the upper surface.

Although an example in which the vibration-damping member 25 that is an independent body is joined to a side surface of the contact body 4 has been described in the present embodiment, this is not a limitation. Exemplary configurations for providing the contact body with a vibration-damping member include the following examples.

As a first exemplary configuration, it is also possible to provide a vibration-damping member by dipping, which is a coating method in which a contact body is immersed in a liquid rubber or a liquid resin. In this case, an endmost portion of the contact body (= a surface parallel to the xz-plane) may be covered by a viscoelastic body, but this does not diminish the effect of suppressing unnecessary vibration. In dipping, for portions (for example, the contact surface and the like) where some inconvenience occurs if the viscoelastic body adheres, it is possible to avoid covering with the viscoelastic locally by providing a mask on the contact body beforehand and removing the mask after the dipping process.

As a second exemplary configuration, it is also possible to provide the vibration-damping member by insert molding, which is a method of performing integral molding by setting the contact body and the reinforcement member in a die and injecting a resin material that has been heated and melted into a space between the contact body and the reinforcement member.

As a third example, it is also possible to form the contact body and the viscoelastic body by double molding. For example, when a resin material is to be used for the contact body as primary forming, PEEK (polyetheretherketone) that has been reinforced by being filled with carbon fiber (carbon fiber) of about 30 wt% may be selected and an elastomer may be used as the viscoelastic body as secondary forming. In this case, by being filled with carbon fiber, increase of the rigidity of the contact body, increase of the wear resistance of the contact surface, and improvement of sliding performance can be expected.

These configurations can not only increase mass-productivity and allow the viscoelastic body to be configured at low cost but also provide an effect of increasing cohesion between the viscoelastic body and the contact body to prevent removal and positional displacement of the viscoelastic body. When the viscoelastic body is to be formed by using a die, it is possible to determine the relative positions of the contact body and the reinforcement member with high precision and to configure a viscoelastic body having a complex shape.

Although an example in which the contact body 4 has a linear shape having the y-direction as the longitudinal direction has been described in the present embodiment, this is not a limitation. It is possible for the contact body to have any curved shape, and, it is possible to suppress unnecessary vibration by providing a vibration-damping member also in a curved contact body. Also when a curved contact body is used, it is possible to fix the vibration body and to cause the contact body to be on the driven side. At this time, it is preferable to configure a contact-body support portion having a shape conforming with the shape of the contact body. Conversely, it is also possible to fix the contact body and to cause the vibration body to be on the driven side, and, in this case, the vibration body unit performs relative movement along the curved contact body.

### Second Embodiment.

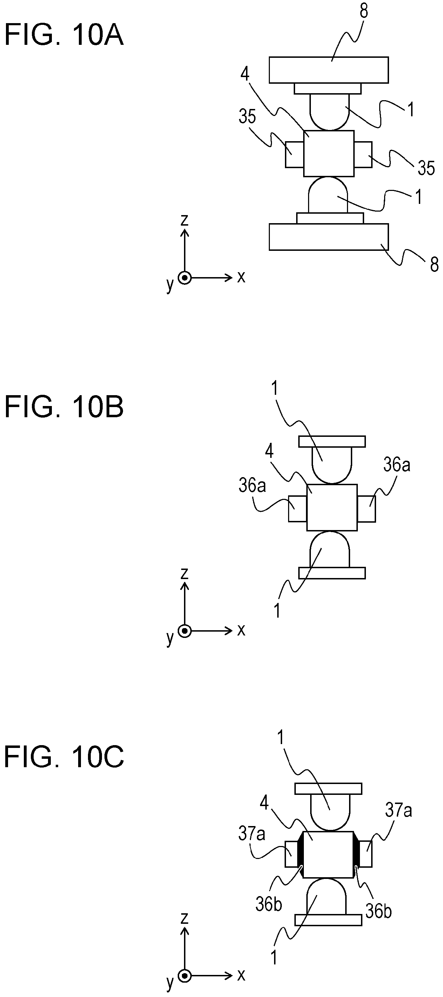

Referring to Figs. 10A to 14, a second embodiment will be described. Constituent elements of the vibration actuator that are similar to those of the first embodiment will be denoted by the same names and numerals, and descriptions of common configurations and functions will be omitted. It is assumed that the orthogonal coordinate system is similar to that in the first embodiment.

Hereafter, referring to Figs. 10A to 10E, measures to suppress unnecessary vibration generated in the contact body 4 in the second embodiment will be described.

Figs. 10A to 10E are right-side views illustrating examples of a contact body unit and the vibration body 1 pressed against the contact body unit.

Fig. 10A is a view illustrating the basic configuration of the contact body unit according to the second embodiment, which is a configuration such that two vibration bodies 1 facing each other are pressed against the contact body 4 of a contact body unit 34. That is, the contact body 4 has contact surfaces on the upper and lower sides (in the positive z-direction and the negative z-direction) thereof. The contact body unit 34 is configured by joining a vibration-damping member 35 to both side surfaces of the contact body 4 in the x-direction. An upper end and a lower end of the vibration-damping member 35 are respectively configured to be located below and above an upper end and a lower end of the contact body 4 in the z-direction. With the shape such that end portions of the vibration-damping member 35 do not protrude further than the upper and lower contact surfaces in this way, it is easy to grind (polish) the contact surfaces to improve smoothness and surface roughness even after the contact body unit 34 has been assembled. As described below in detail, the vibration-damping member 35 is constituted by a viscoelastic body or by a combination of a viscoelastic body and a reinforcement member.

By pressing a plurality of vibration bodies 1 against the contact body 4, it is possible to increase thrust compared with the first embodiment described with reference to Figs. 4A to 4G. Moreover, by disposing the vibration bodies 1 so as to face each other, it is possible to increase the commonality of the pressing support mechanisms for these vibration bodies 1 as described below. Thus, it is possible to increase thrust per volume or per weight, and the layout is suitable for high-density packaging.

Figs. 10B to 10E are views for describing exemplary configurations of the vibration-damping member, illustrating configurations such that two vibration bodies 1 facing each other are pressed against the contact body 4 of the contact body unit.

Fig. 10B is a view illustrating a contact body unit 34a, which is an example in which the vibration-damping member includes only a viscoelastic body 36a, as with the contact body unit 24a described with reference to Fig. 4B. In the contact body unit 34a, the viscoelastic body 36a is joined to both side surfaces of the contact body 4 in the x-direction. The characteristics and the materials of the vibration-damping member and the mechanism for suppressing unnecessary vibration are similar to those of the contact body unit 24a, and descriptions thereof will be omitted here.

Fig. 10C is a view illustrating a contact body unit 34b, which is an example in which the vibration-damping member includes a combination of a viscoelastic body 36b and a reinforcement member 37a, as with the contact body unit 24c described with reference to Fig. 4D. In the contact body unit 34b, the viscoelastic body 36b is joined to both side surfaces of the contact body 4 in the x-direction, and the reinforcement member 37a is joined to the viscoelastic body 36b. The characteristics and the materials of the vibration-damping member and the mechanism for suppressing unnecessary vibration are similar to those of the contact body unit 24c, and descriptions thereof will be omitted here.

Fig. 10D is a view illustrating a contact body unit 34c, which is an example in which the vibration-damping member has a multilayer structure in which a plurality of viscoelastic bodies 36c and a plurality of reinforcement members 37b are alternately arranged, as with the contact body unit 24e described with reference to Fig. 4E. In the contact body unit 34c, a viscoelastic body 36c and a reinforcement member 37b are joined from both sides of the contact body 4 in the x-direction, and another set of a viscoelastic body 36c and a reinforcement member 37b are further joined. The characteristics and the materials of the vibration-damping member and the mechanism for suppressing unnecessary vibration are similar to those of the contact body unit 24e, and descriptions thereof will be omitted here.

Fig. 10E is a view illustrating a contact body unit 34d, which is an example in which the vibration-damping member includes a combination of a viscoelastic body 36d using an adhesive and a reinforcement member 37e, as with the contact body unit 24f described with reference to Fig. 4G. Although the example illustrated in 4G is an example in which the vibration-damping member is provided on only one side surface of the contact body 4 in the x-direction, here, the vibration-damping member is provided on both side surfaces of the contact body 4 in the x-direction. The characteristics and the materials of the vibration-damping member and the mechanism for suppressing unnecessary vibration are similar to those of the contact body unit 24f, and descriptions thereof will be omitted here.

In the following description, various contact body units and vibration-damping members (viscoelastic bodies, reinforcement members) described with reference to Figs. 10A to 10E may be referred to as the contact body unit 34, the vibration-damping member 35, the viscoelastic body 36, and the reinforcement member 37 by using representative numerals.

As described above, by providing the vibration-damping member 35 on a side surface of the contact body 4, it is possible to suppress unnecessary vibration generated in the vibration actuator and to prevent output power (thrust) per volume or per weight from becoming small.

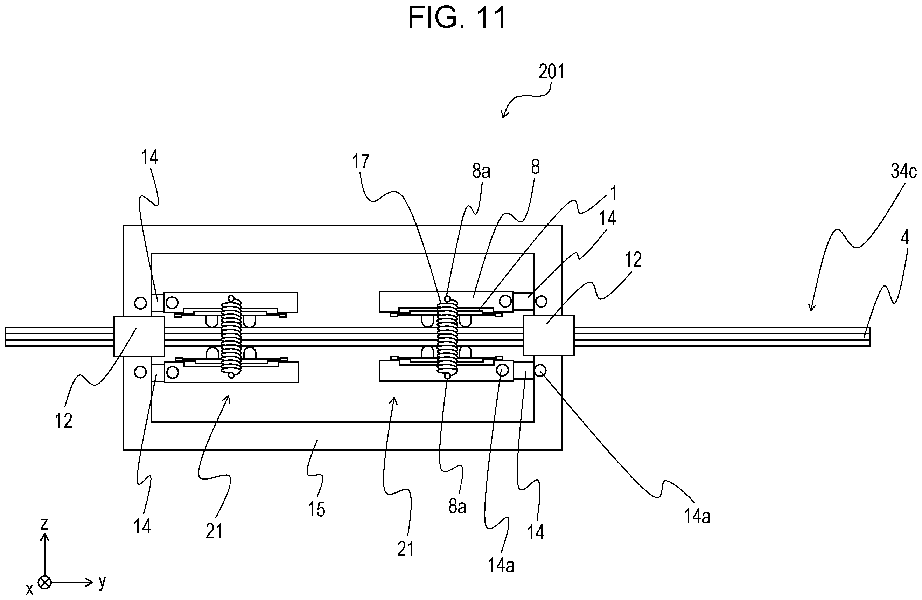

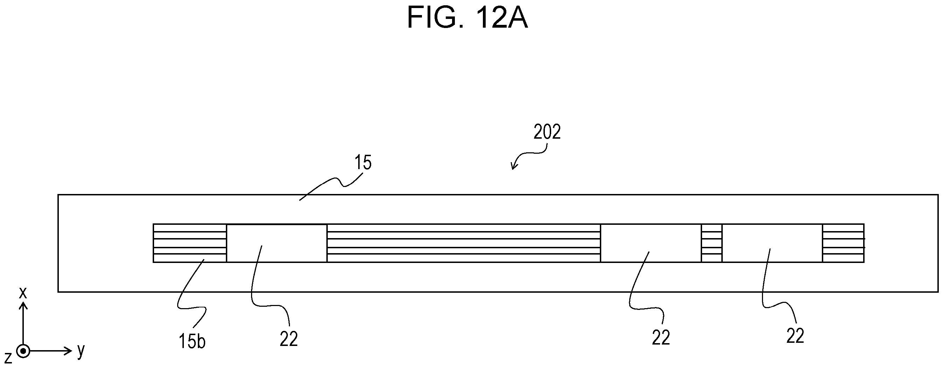

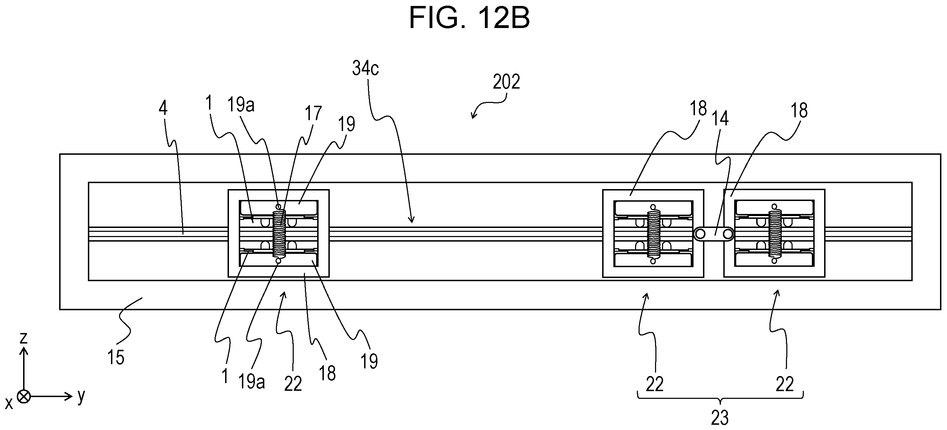

Next, referring to Figs. 11, 12A, and 12B, examples of a support structure of the vibration body 1 and the contact body 4 in the second embodiment will be described.

Fig. 11 is a front view illustrating a schematic configuration of a vibration actuator 201 according to the second embodiment.

The vibration actuator 201 includes two vibration body units 21 and the contact body 4 that contacts the vibration bodies 1 of the vibration body units 21. Here, the contact body unit 34c described above (referred to as the contact body 4 in the following description) is used in order to suppress unnecessary vibration generated in the contact body 4. Various components of the vibration actuator 201 are assembled on the support member 15 that is a base member.

Each vibration body unit 21 includes two vibration bodies 1, the nonwoven cloths 16, a pressing portion 17, and the holding portions 8. The vibration bodies 1 facing each other are pressed against the contact body 4 by hooking ends of the pressing portion 17 on hooks 8a provided on side surfaces of the holding portions 8. In the present embodiment, a tension spring is used as the pressing portion 17. As with the vibration actuator 101 described with reference to Fig. 7, each holding portion 8 is attached to the support member 15 via the coupling portion 14 to perform positioning of the contact body 4 in the z-direction, and the vibration bodies 1 and the holding portions 8 are slidable in the z-direction. This configuration is a configuration such that the three sets of reaction-force receiving portions 9 and rotation support portions 10 of the vibration actuators 101 are replaced with the vibration bodies 1 and the holding portions 8. Here, the projections 2a of the vibration body 1 serve as the reaction-force receiving portions 9.

As with the vibration actuator 101 described with reference to Fig. 7, the contact body 4 is supported by the support member 15 in a state of being movable in the y-direction due to thrust that the contact body 4 receives from the vibration body 1 included in each vibration body unit 21. To be specific, in the support member 15, four rollers that are rotatable around axes parallel to z-axis are provided as contact-body support portions 12 that movably support the contact body 4. The four contact-body support portions 12 function as a linear guide that allows the contact body 4 to move in the y-direction by constraining the degree of freedom of a side surface of the reinforcement member 37b in the xy-plane.

With the vibration actuator 201 having such a configuration, it is possible to reduce constituent elements such as the reaction-force receiving portion 9 and the rotation support portion 10 by supporting the contact body 4 in the z-direction by using four vibration bodies 1. Moreover, it is possible to increase the thrust of the vibration actuator 201 by using the vibration body unit 21 instead of the reaction-force receiving portion 9 and the rotation support portion 10. If the vibration body 1 used in the vibration actuator 101 and the vibration body 1 used in the vibration actuator 201 have the same performance, the vibration actuator 201 can obtain thrust that is four times larger than the thrust obtained by the vibration actuator 101. With the configuration of the contact body unit 34c described above, it is possible to increase the effect of suppressing unnecessary vibration generated in the contact body 4 and to prevent generation of noise and decrease of performance due to unnecessary vibration. Moreover, it is possible to reduce the thickness of the viscoelastic body in the x-direction compared with the contact body units 34a and 34b. By reducing the thickness of the viscoelastic body, it is possible to reduce displacement of the vibration-damping member in the xy-plane when an external force is applied to the contact body unit 34c via the reinforcement member 37b, and it is possible to increase rigidity as a linear guide.

In this way, it is possible to suppress unnecessary vibration generated in the vibration actuator and to increase output power (thrust) per volume or per weight.

Figs. 12A and 12B are views illustrating schematic configurations of another vibration actuator 202 according to the second embodiment. Fig. 12A is a plan view of the vibration actuator 202, and Fig. 12B is a front view of the vibration actuator 202.

The vibration actuator 202 includes three vibration body units 22 and the contact body 4 that contacts the vibration bodies 1 of the vibration body units 22, the contact body 4 is fixed to the support member 15, and the vibration bodies 1 perform relative movement. Here, the contact body unit 34c described above (referred to as the contact body 4 in the following description) is used in order to suppress unnecessary vibration generated in the contact body 4. Constituent elements of the vibration actuator 202 that correspond to those of the vibration actuator 201 (see Fig. 11) will be denoted by the same names and numerals, and descriptions of common configurations and functions will be omitted.

In the vibration actuator 202, among the three vibration body units 22, two vibration body units 22 at the center and on the right side are coupled to each other by the coupling portion 14 to constitute a vibration body unit group 23. Both ends of the contact body 4 are fixed to the support member 15. In each vibration body unit 22, the spacer 19 to which the nonwoven cloth 16 is affixed is disposed inside of the holding portion 18. The vibration body unit 22 is a unit such that the reaction-force receiving portion 9 and the rotation support portion 10 of the vibration body unit 11 used in the vibration actuator 102 are replaced with the vibration body 1 and the spacer 19. The vibration bodies 1 facing each other are pressed against the contact body 4 by hooking ends of the pressing portion 17 on hooks 19a provided on the spacer 19. In the vibration body unit 22, it is assumed that the two vibration bodies 1 are supported by the holding portions 18 to be slidable in the z-direction, and the degree of freedom other than that in the z-direction is constrained with respect to the holding portions 18. As with the vibration actuator 102 described with reference to Figs. 9A to 9C, the opening 18a is provided in the holding portion 18 and functions as a linear guide that allows the vibration body unit 22 to move in the y-direction.

Among the three vibration body units 22, the vibration body unit 22 on the left side can be driven in the y-direction. On the other hand, the vibration body units 22 at the center and at the right end are coupled to each other by the coupling portion 14 via the holding portion 18 to be slidable relative to each other in the z-direction. At this time, it is desirable that the coupling portion 14 be provided to be offset in the x-direction so as not to interfere with the contact body 4. It is possible to drive the vibration body unit group 23, which is constituted by the two coupled vibration body units 22, together in the y-direction.

With the vibration actuator 202, it is possible for the left vibration body unit 22 and the vibration body unit group 23 to move independently in the y-direction. By providing an opening 15b in the support member 15 as illustrated in Fig. 12A, it is possible to expose the upper surfaces of the left vibration body unit 22 and the vibration body unit group 23 to the outside, and it is possible to connect an object to be driven to the upper surfaces.

With the vibration actuator 202 configured as described above, it is possible to independently drive the plurality of vibration body units 22 or the vibration body unit group 23 via one contact body 4. At this time, by using the contact body unit 34c, it is possible to effectively suppress unnecessary vibration excited in the contact body. Moreover, since the two vibration body units 22 are coupled to constitute the vibration body unit group 23, it is possible for the vibration body unit group 23 to generate thrust that is four times larger than that of the vibration body unit 11. At this time, by coupling the vibration body units 22 so as to be movable relative to each other in the z-direction, each vibration body 1 conforms to the contact body 4 with respect to deformation of the contact body in the longitudinal direction (in the yz-plane), and thus it is possible to reduce variation in pressing reaction force applied to each vibration body 1. Thrust decreases in a vibration body 1 to which a relatively small pressing reaction force is applied, and a risk of wear due to overload or the like occurs in a vibration body 1 to which a relatively large pressing reaction force is applied. By configuring the vibration body unit group 23, it is possible to reduce variation in pressing reaction force and to efficiently generate thrust in each vibration body 1.

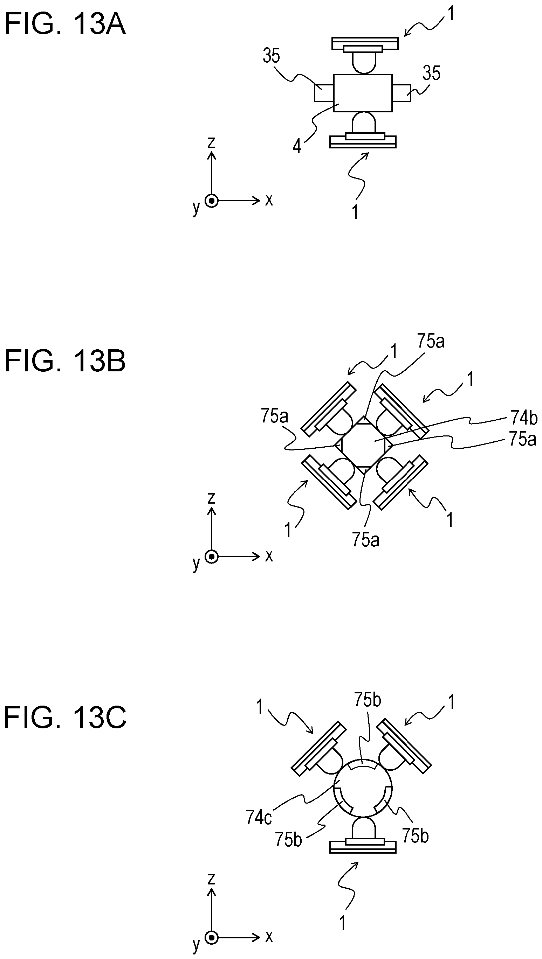

Next, referring to Figs. 13A to 13F, exemplary configurations such that a plurality of vibration bodies 1 are pressed against a contact body will be described.

Figs. 13A to 13F are right side views for describing examples of a contact body unit and the vibration bodies 1 pressed against the contact body unit.

Fig. 13A illustrates a configuration such that two vibration bodies 1 facing each other support the contact body 4, which is a configuration similar to those described with reference to Figs. 10A to 10E.

Fig. 13B illustrates a configuration such that a contact body 74b having a polygonal cross section is supported by disposing vibration bodies 1 on four side surfaces of the contact body 74b. Four vibration-damping members 75a are joined to the contact body 74b at positions displaced from the vibration bodies 1 to constitute a contact body unit having a rectangular cross section. The vibration-damping members 75a are similar to the vibration-damping members 25 and 35 described above.

Fig. 13C illustrates a configuration such that a side surface (curved surface) of a contact body 74c having a substantially circular cross section is supported by three vibration bodies 1 that are arranged at substantially 120° interval in the zx-plane. Three fan-shaped vibration-damping members 75b are joined to the side surface of the contact body 74c to constitute a contact body unit having a circular cross section. The vibration-damping members 75b are similar to the vibration-damping members 25 and 35 described above.

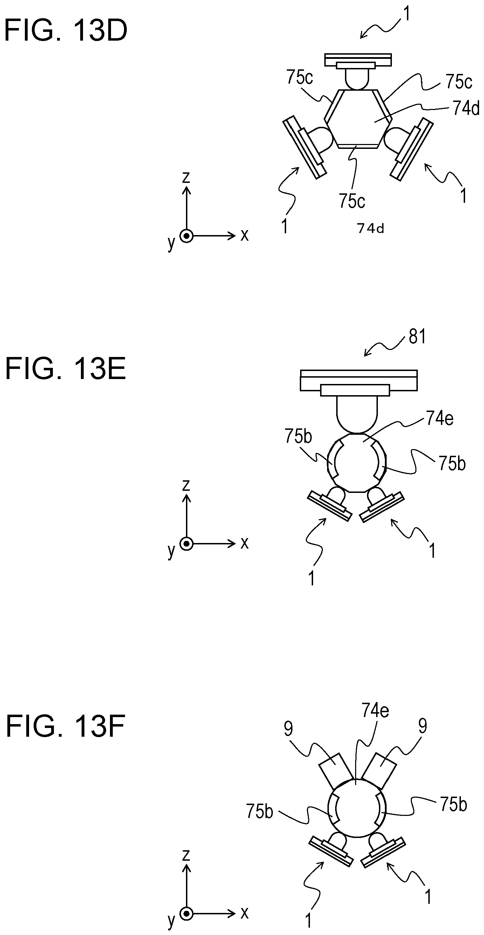

Fig. 13D illustrates a configuration such that a contact body 74d having a polygonal (here, hexagonal) cross section is supported by disposing vibration bodies 1 on three side surfaces that are not adjacent to each other, among the side surfaces of the contact body 74d. Three vibration-damping members 75c are joined to the other three side surfaces of the contact body 74d against which the vibration bodies 1 are not pressed. The vibration-damping members 75c are similar to the vibration-damping members 25 and 35 described above.

Fig. 13E illustrates a configuration such that a side surface (curved surface) of a contact body 74e having a substantially circular cross section is supported by vibration bodies 1 and 81 whose size and thrust differ from each other. As with the case of Fig. 13C, two fan-shaped vibration-damping members 75b are joined to the side surface of the contact body 74e to constitute a contact body unit having a circular cross section.

Fig. 13F illustrates a configuration such that a side surface (curved surface) of the contact body 74e having a substantially circular cross section is supported by two vibration bodies 1 and two reaction-force receiving portions 9. As with the case of Fig. 13C, two fan-shaped vibration-damping members 75b are joined to the side surface of the contact body 74e to constitute a contact body unit having a circular cross section.

By appropriately combining these configurations, it is possible to appropriately support a contact body having any of various cross-sectional shapes by using vibration bodies. By providing vibration-damping members on the side surface of the contact body, it is possible to suppress unnecessary vibration generated in a vibration actuator and to prevent output power (thrust) per volume or per weight from becoming small.

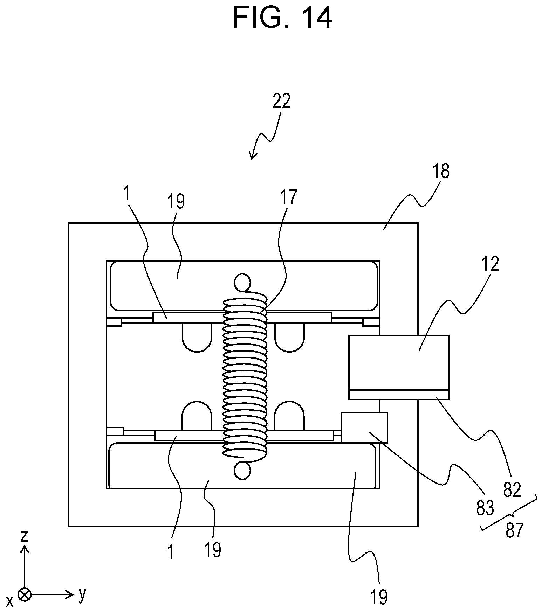

Next, referring to Fig. 14, an example in which a vibration body unit of a vibration actuator has a function of displacement detection will be described.

Fig. 14 is a front view illustrating a state in which a displacement-detecting portion 87 is attached to the vibration body unit 22. Although the vibration body unit 22 is described here, it is also possible to mount the displacement-detecting portion 87 on another vibration body unit.

The displacement-detecting portion 87 includes a scale 82 and the detector 83. The scale 82 is attached to the contact-body support portion 12, which is provided on the holding portion 18, at a position that does not physically interfere with (does not contact) the contact body 4 (not shown in Fig. 14). The scale 82 rotates together with the contact-body support portion 12 in accordance with displacement of the contact body 4. The detector 83 detects the movement amount of the contact body 4 in the y-direction by reading the rotational displacement of the scale 82. The detector 83 includes a light source and a light receiver, and can read the rotational displacement of the scale 82 by emitting light from the light source to the scale 82 and receiving reflection of the light with the light receiver. Based on the movement amount of the contact body 4 in the y-direction output by the detector 83, it is possible to control drive parameters such as the position, the velocity, the acceleration, and the like of the contact body 4.

As the displacement-detecting portion 87, various types such as an optical type, a magnetic type, a capacitance type, and the like can be used. Although the displacement-detecting portion 87 described here is of a reflective optical type, a transmissive optical type can also be used. Moreover, instead of the displacement-detecting portion 87 of a rotational type, a linear displacement-detecting portion in which a linear scale is disposed on the contact body 4 and a detector is disposed in the vibration body unit may be used.

### Third Embodiment.

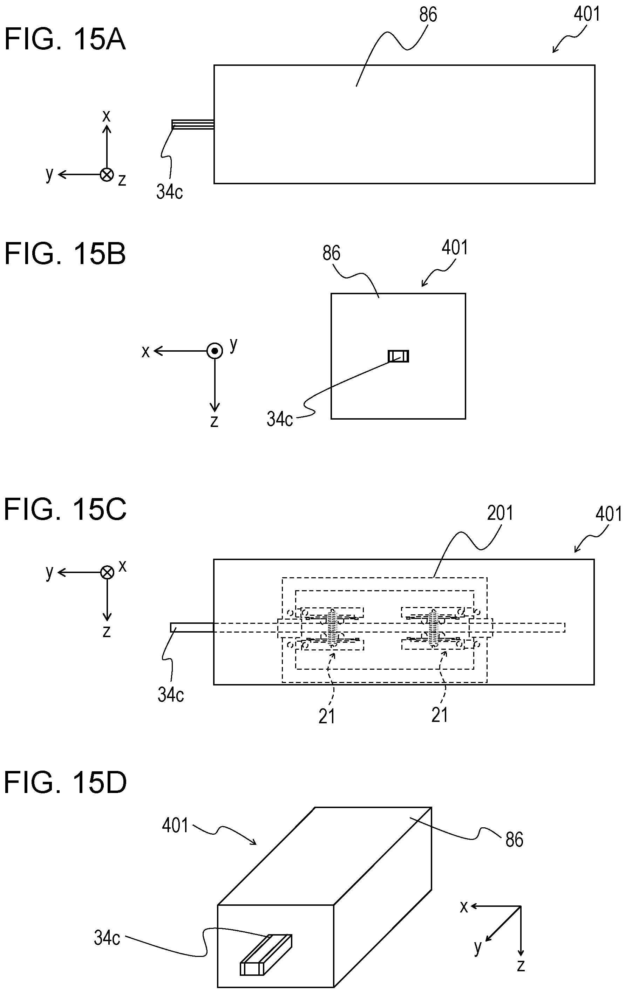

Referring to Figs. 15Ato 15D, a third embodiment will be described. In the third embodiment, an actuator unit in which a vibration actuator is unitized (packaged) by using an outer member will be described. Constituent elements of the vibration actuator that are similar to those of the first embodiment will be denoted by the same names and numerals, and descriptions of common configurations and functions will be omitted. It is assumed that the orthogonal coordinate system is similar to that in the first embodiment.

Figs. 15A to 15D are views illustrating schematic configurations of an actuator unit 401 according to the third embodiment. Figs. 15Ato 15D are respectively a plan view (top view), a side view, a front view, and a perspective view of the actuator unit 401.

The actuator unit 401 is formed by unitizing the vibration actuator 201 by using an outer member 86. In the actuator unit 401, the support member 15 of the vibration actuator 201 is movably fixed to an inner bottom surface of the outer member 86. Motive power of the contact body 4 is output as the contact body 4 moves in the y-direction in a state of extending through an end surface (the zx-plane) of the outer member 86. That is, a part of the contact body unit 34c of the vibration actuator 201 is led to the outside of the outer member 86 to allow connection of a load. In Fig. 15C, the vibration body unit 21 and the like, which are covered by the outer member 86 and invisible, are shown by broken lines.

In this way, by configuring the actuator unit 401 by unitizing the vibration actuator 201 by using the outer member 86, it is possible for a user to grip and safely handle the outer member 86, and it is possible to protect the vibration actuator 201.

Although an example in which the vibration actuator 201 is unitized has been described here, it is possible to unitize any of the vibration actuators described above by using an outer member without exception. The outer member may be integrated with the support member 15 and/or the like.

### Fourth Embodiment.

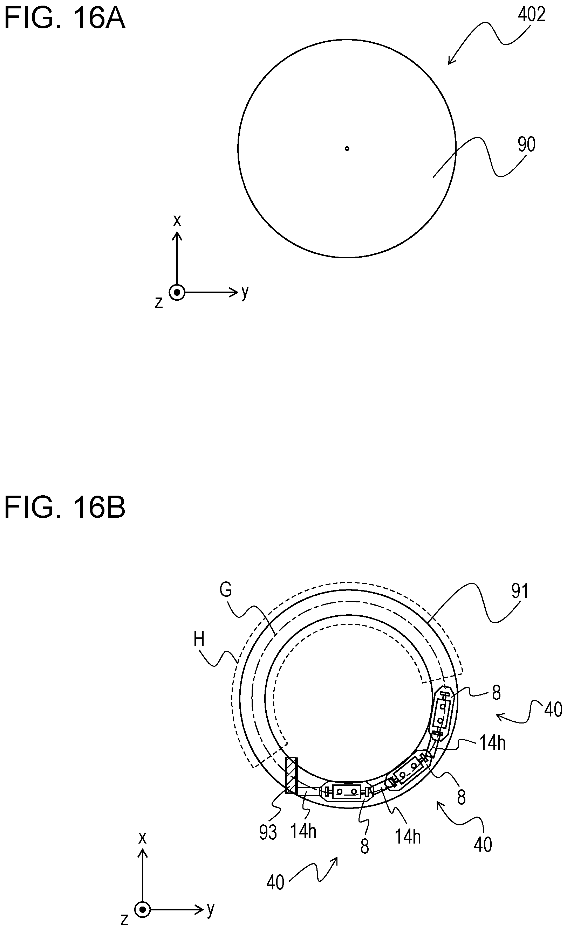

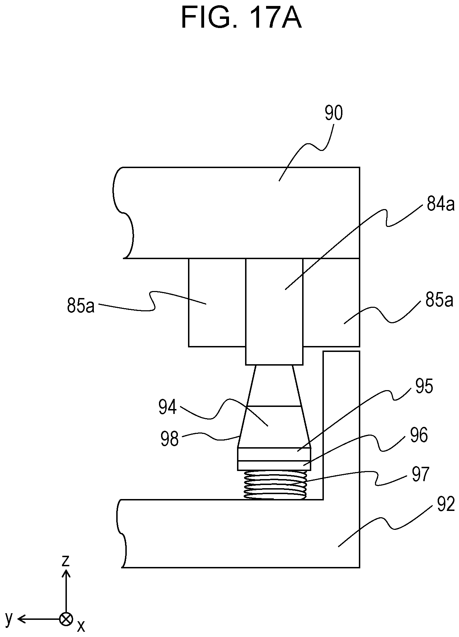

Referring to Figs. 16A to 16D and 17A to 17C, a fourth embodiment will be described. In the fourth embodiment, an actuator unit in which a vibration actuator is unitized (packaged) by using an outer member will be described. Constituent elements of the vibration actuator that are similar to those of the first embodiment will be denoted by the same names and numerals, and descriptions of common configurations and functions will be omitted. It is assumed that the orthogonal coordinate system is similar to that in the first embodiment.

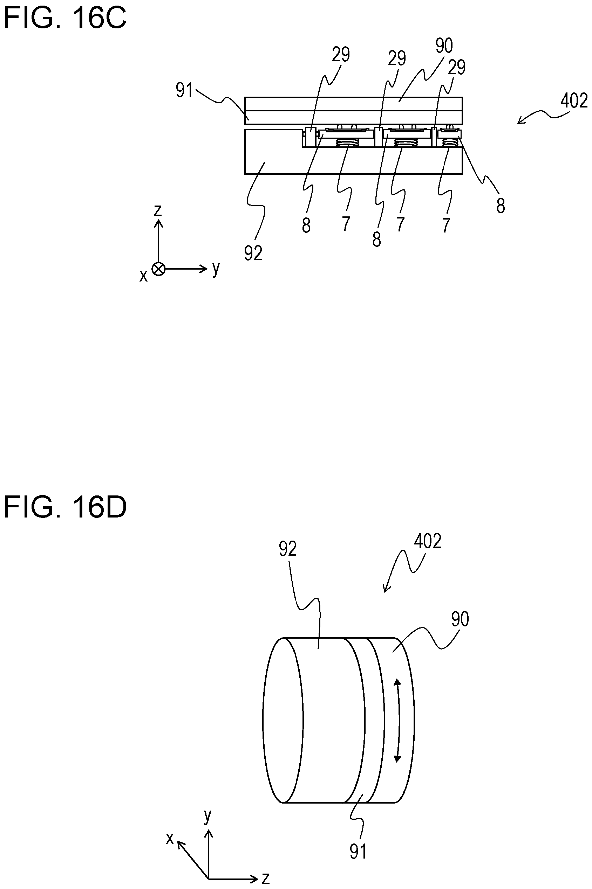

Figs. 16A to 16D are views illustrating schematic configurations of an actuator unit 402 according to the fourth embodiment. Fig. 16A, 16C, and 16D are respectively a plan view (top view), a side view, and a perspective view of the actuator unit 402. Fig. 16B is a plan view in which outer members 90 and 92 and a displacement suppressing portion 29 are not illustrated.

In the actuator unit 402, three vibration body units 40 are held by a cylindrical outer member 92. In the vibration body units 40, the holding portions 8 that respectively hold the vibration bodies 1 are coupled by coupling portions 14h described below and are disposed on the circumference of the outer member 92.

The contact body 91 has an annular (ring-like) shape and one of xy-surfaces thereof contacts the projecting portions 2a of the three vibration bodies 1 in a state in which the contact body 91 is rotatably supported by a rotational support mechanism (not shown). The rotational support mechanism of the contact body 91 is, for example, an axial support mechanism including a ball-and-roller bearing, a plain bearing, or the like. The outer member 90 is attached to the other xy-surface of the contact body 91.

With the actuator unit 402, when the vibration body units 40 are driven, the contact body 91 and the outer member 90 rotate in an integrated manner relative to the outer member 92 around an axis that passes through the center of the xy-surface of the outer member 90 and that is parallel to the z-axis. That is, the actuator unit 402 outputs the rotational motion of the outer member 90 to the outside as motive power.

The configuration of the vibration body unit 40 will be described in further detail. The vibration body unit 40 includes the holding portion 8, the vibration body 1, the pressing portion 7, and a spacer to which a nonwoven cloth (not shown) is affixed. A structure with which the vibration body 1 is pressed against the contact body 91 by using the pressing portion 7 is similar to the structure with which the vibration body 1 is pressed against the contact body 4 by using the vibration body unit 5, which has been described regarding the vibration actuator 101 (see Fig. 7). Among the three vibration body units 40, the vibration body unit 40 on the left side in Fig. 16C is coupled to a support member 93 fixed to the outer member 92 by using the coupling portion 14h, and the remaining two vibration body units 40 are successively coupled to the right side by using the coupling portion 14h. Thus, the vibration bodies 1 of the three vibration body units 5 can become displaced to follow the deformation of the contact body 4 even if deformation such as warping or the like has occurred in the contact body 4 in the circumferential direction.

With the actuator unit 402, in order to prevent displacement of the vibration body unit 40 in the radial direction, the coupling portion 14h is constrained by the displacement suppressing portion 29 fixed to the outer member 92. At this time, it is desirable to appropriately design the shape of the coupling portion 14 and the position of the displacement suppressing portion 29 so that the vibration body 1 can frictionally slide along an alternate long and short dash line G (Fig. 16B) that is approximately at the center of the contact body 91. By coupling the vibration body units 40 in the circumferential direction by using the coupling portions 14, it is possible to create a large vacant space surrounded by a broken line H in Fig. 16B. It is possible to reduce the size of the actuator unit 402 by effectively using the created vacant space as a space for disposing a displacement-detecting portion, a circuit board, and the like.

In this way, by unitizing the vibration body unit 40 and the contact body 91 by using the outer members 90 and 92, as with the third embodiment, it is possible to grip and safely handle the outer members 90 and 92, and it is also possible to protect the vibration body unit 40.

Although an example in which the actuator unit 402 is configured by using three vibration body units 40 has been described with reference to Figs. 16Ato 16D, it is possible to provide a similar actuator unit by using an annular vibration body 98 instead of the vibration body 1 as illustrated in Figs. 17A to 17C.

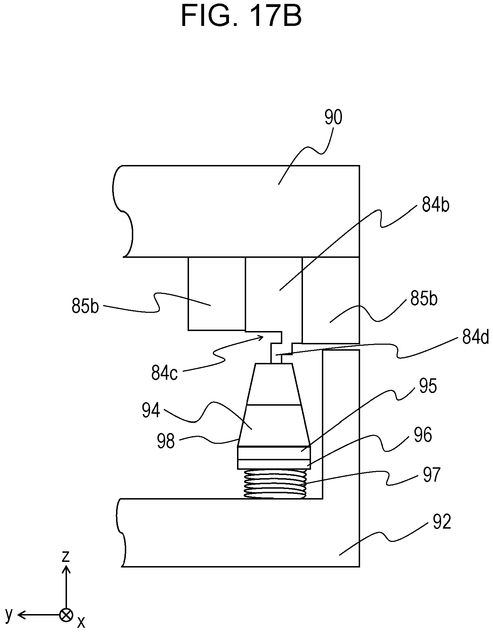

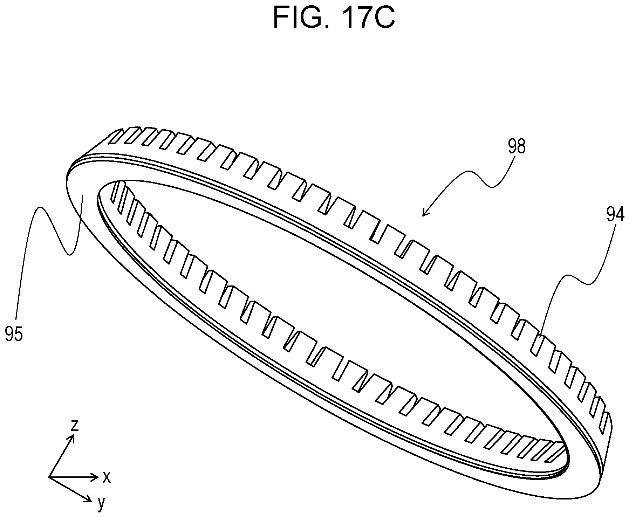

Figs. 17A to 17C are views illustrating schematic configurations of another actuator unit according to the fourth embodiment. Figs. 17A and 17B are sectional views of the actuator unit, and Fig. 17C is a perspective view of the vibration body 98. The vibration body 98 includes a ring-shaped elastic body 94 and an electric-mechanical energy conversion element 95 joined to a bottom surface of the elastic body 94. The elastic body 94 has a comb-tooth shape in which a plurality of grooves are provided on the upper surface side (the elastic body 94 side) in the circumferential direction. A flexible substrate (not shown) is joined to the electric-mechanical energy conversion element 95, and a nonwoven cloth 96 is provided below the flexible substrate in the z-axis direction. A pressing portion 97 is inserted below the nonwoven cloth 96 in the z-axis direction. The pressing portion 97 includes a plurality of coil springs arranged in the circumferential direction, a coned-disc spring, a wave washer, or the like.

As illustrated in Fig. 17A, the elastic body 94 is pressed against a contact body 84a. A vibration-damping member 85a is joined to each of an inner peripheral surface and an outer peripheral surface of the contact body 84a. The vibration-damping member 85a is similar to the vibration-damping members 25 and 35 described above. By applying an alternating voltage to the electric-mechanical energy conversion element 95, it is possible to excite out-of-plane vibration with respect to the xy-plane in the vibration body 98. By applying a plurality of alternating voltages with different phases at a predetermined frequency in the vicinity of an out-of-plane vibration mode of the vibration body 98, it is possible to generate a progressive wave at an upper surface of the vibration body 98 and to rotate the contact body 84a by frictional force.

As an example in which the shape of the contact body is changed, as illustrated in Fig. 17B, the elastic body 94 is pressed against a contact body 84b. The rigidity of a contact portion 84d in the z-direction is reduced by providing the contact body 84b with a flange portion 84c where the contact body 84b is cut out in the circumferential direction. Thus, it is possible to allow the contact portion 84d to follow the displacement of the vibration body 98 that performs out-of-plane vibration. By absorbing the displacement in the z-direction, it is possible to efficiently rotate the contact body 84b in the circumferential direction. A vibration-damping member 85b is joined to each of an inner peripheral surface and an outer peripheral surface of the contact body 84b. The vibration-damping member 85b is similar to the vibration-damping members 25 and 35 described above.

In common between the third and fourth embodiments, it is desirable to unitize the actuator unit by selecting the configuration of the vibration actuator in accordance with the specifications of an apparatus to which the actuator unit is to be applied and by appropriately adjusting the arrangement and the number of vibration body units.

In the following embodiments, application examples of the vibration actuator described above, that is, various apparatuses and various machines in each of which the vibration actuator is mounted will be described.

### Fifth Embodiment.

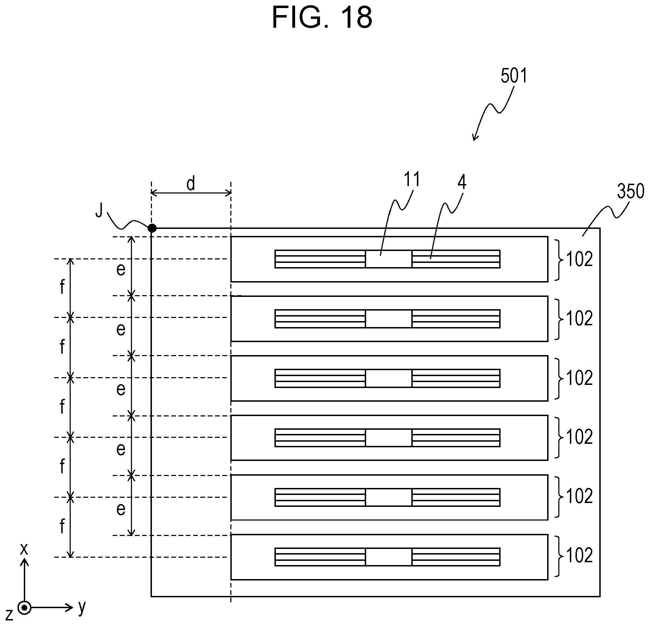

Referring to Fig. 18, a fifth embodiment will be described. Fig. 18 is a plan view illustrating a schematic configuration of an apparatus 501 according to the fifth embodiment. The apparatus 501 includes six vibration actuators 102 and a support member 350. The six vibration actuators 102 are fixed to the support member 350 via the support member 15 and with the support member 15 as a reference position. The support member 350 corresponds to the support member 15 magnified in the xy-plane, and is configured as one member.

As in the apparatus 501, it is easy to arrange the six vibration actuators 102 to be aligned on a plane. For example, it is easy to align and arrange the six vibration actuators 102 so as to be separated from a reference position J of the support member 350 by a distance d in the y-direction and so that the arrangement interval between adjacent support members 15 in the x-direction is a distance e. In this case, it is possible to make the intervals between the contact bodies 4 of the vibration actuators 102 that are adjacent in the x-direction be the same distance f. The vibration body units 11 of the six vibration actuators 102 may be coupled to one drive component (load) or may be coupled to different drive components (loads).

The apparatus 501 described here includes the six vibration actuators 102, and it is possible to configure a similar apparatus by using any plurality of vibration actuators 102. Depending on the configuration of the apparatus, a plurality of vibration actuators can be disposed at different positions on the same plane or on different planes.

With the vibration actuator 102, as described above, it is possible to set the width dimension of the contact body 4 in the x-direction as small as possible and to suppress unnecessary vibration by using the vibration-damping member 35. Accordingly, it is possible to reduce the size of the apparatus when the plurality of vibration actuators 102 are arranged in the x-direction and used as in the apparatus 501. Moreover, it is possible to further reduce the size by arranging the vibration actuators 102 so as to contact each other as illustrated in Fig. 18. Furthermore, it is possible to considerably reduce the size by forming the support member 15 and the support member 350 of the vibration actuator 102 as an integrated component to make the dimension of the support member in the x-direction as small as possible in a range such that the vibration body unit 11 does not interfere.

### Sixth Embodiment.

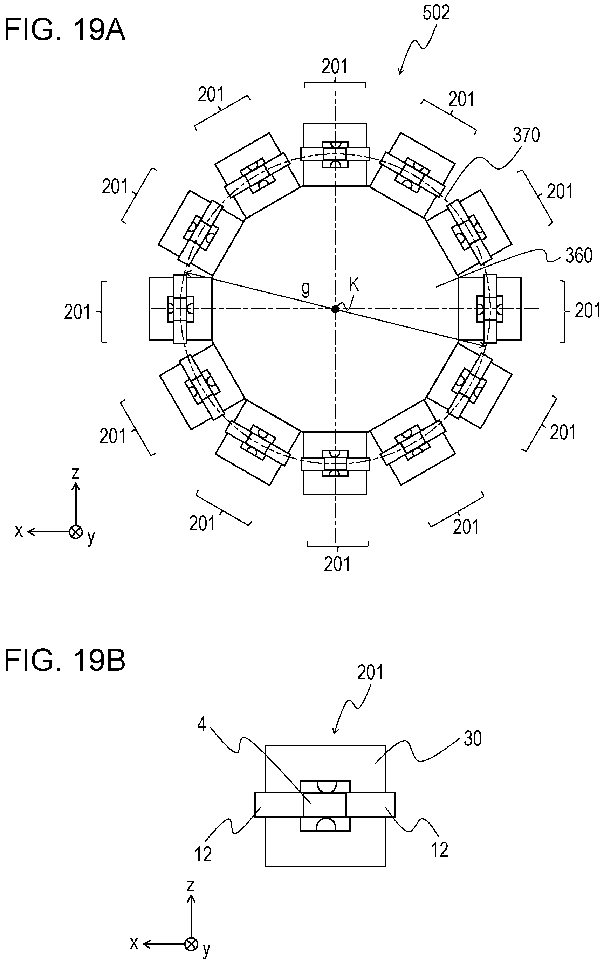

Referring to Figs. 19A and 19B, a sixth embodiment will be described. Figs. 19A and 19B are views illustrating schematic configurations of an apparatus 502 according to the sixth embodiment. Fig. 19A is a plan view of the apparatus 502, and Fig. 19B is a side view illustrating a schematic configuration of a vibration actuator 201 of the apparatus 502. The apparatus 502 includes twelve vibration actuators 201 and a support member 360. The support member 360 is formed by integrating twelve support members 15 of the twelve vibration actuators 201 into one member having a prismatic shape so that the cross section thereof perpendicular to the y direction has a substantially regular dodecagonal shape centered at a point K with the y direction as the axial direction. The twelve vibration actuators 201 are radially fixed respectively to twelve side surfaces (surfaces parallel to the y-axis) corresponding to the sides of the substantially regular dodecagonal shape of the zx cross section of the support member 360 via the support members 15 and with reference to the support members 15. Thus, with the apparatus 502, it is possible to arrange the plurality of contact bodies 4 with high precision on the circumference of a pitch circle 370 that has a diameter g and that is centered at the point K as seen from the y-direction. As with the fourth embodiment, by setting the width dimension of the contact body 4 as small as possible and suppressing unnecessary vibration by using the vibration-damping member, it is possible to set the diameter g small and to reduce the size of the apparatus 502. Moreover, similarly, by forming the support member 15 and the support member 360 of the vibration actuator 102 as an integrated component, it is possible to substantially reduce the size.

Although the vibration actuators 201 are disposed on all side surfaces of the support member 360 in the apparatus 502, the vibration actuators 201 can be disposed at any positions on any side surfaces. The support member 360 is not limited to a dodecagonal prism and can be changed to any polygonal prism.

### Seventh Embodiment.

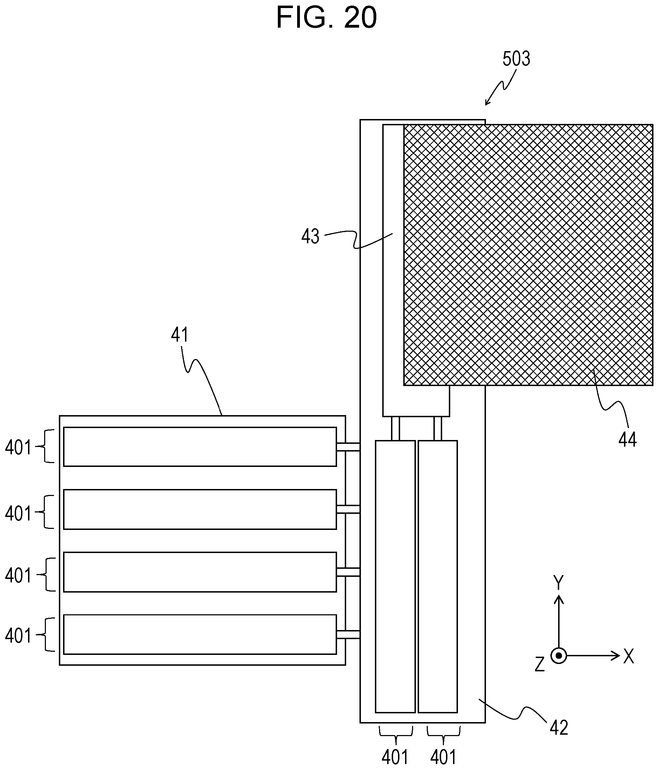

Referring to Fig. 20, a seventh embodiment will be described. In the seventh embodiment, a multi-axis stage including a vibration actuator will be described.

Fig. 20 is a plan view illustrating a schematic configuration of a multi-axis stage 503 according to the seventh embodiment. The multi-axis stage 503 includes a fixed portion 41, an x-stage 42, a y-stage 43, and an xy-stage 44.

The degree of freedom of the fixed portion 41 is constrained in all directions, and the fixed portion 41 is immovable. As with the apparatus 501 described with reference to Fig. 18, four actuator units 401 (see Figs. 15A to 15D) are arranged in the y-direction and fixed to the fixed portion 41. Four contact bodies 4 of the four actuator units 401 fixed to the fixed portion 41 are movable in the x-direction in Figs. 15A to 15D, and a right end of each of the contact bodies 4 is fixed to the x-stage 42.

The x-stage 42 is movable only in the x-direction, the degree of freedom in the other directions are constrained, and the x-stage 42 is driven in the x-direction by the four actuator units 401 fixed to the fixed portion 41. Two actuator units 401 are fixed to the x-stage 42 to be arranged in the x-direction. Two contact bodies 4 of the two actuator units 401 fixed to the x-stage 42 are movable in the y-direction in Fig. 20, and an upper end of each of the contact bodies 4 is fixed to the y-stage 43.

The y-stage 43 is movable only in the y-direction, the degree of freedom in the other directions are constrained, and the y-stage 43 is driven in the y-direction by the two actuator units 401 fixed to the x-stage 42. The xy-stage 44 is fixed to the y-stage 43. The xy-stage 44 moves in the xy-plane in accordance with the movement of the x-stage 42 and/or the y-stage 43.

A mass that the actuator units 401 provided on the fixed portion 41 move is larger than a mass that the actuator units 401 provided on the x-stage 42 move. In consideration of this, the number of actuator units 401 to be disposed on the fixed portion 41 and the number of actuator units 401 to be disposed on the x-stage 42 may be set in correspondence with the mass of an object be moved. Although the multi-axis stage 503 is configured as an xy-stage having two degrees of freedom, it is possible to realize a stage having any degrees of freedom by using a plurality of actuator units 401.

Since the multi-axis stage 503 is configured so that the plurality of actuator units 401 move an object to be driven in a predetermined direction, generation of a moment in a plane parallel to the xy-plane is suppressed. As a result, it is possible to move the xy-stage 44 with high precision in the xy-plane.

Also with the present embodiment, it is possible to reduce the size of the stages 41 and 42 by setting the width dimension of the contact body 4 in the x-direction as small as possible and suppressing unnecessary vibration by using the vibration-damping member.

### Eighth Embodiment.

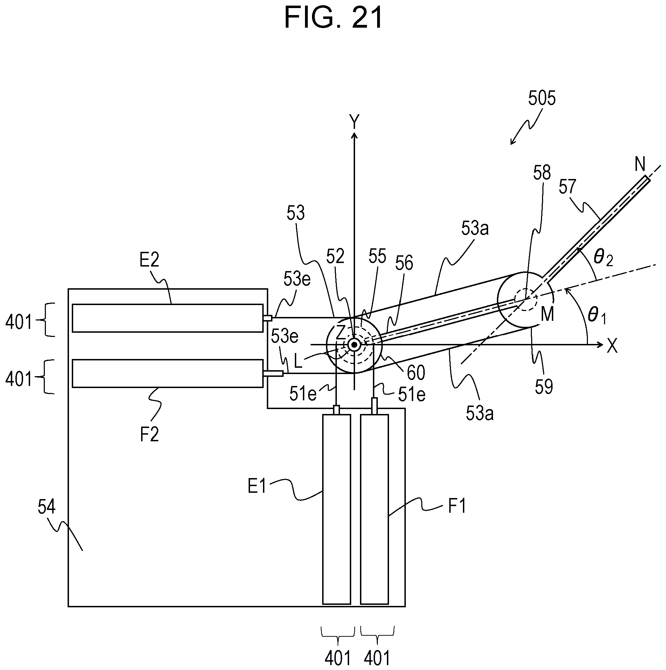

Referring to Fig. 21, an eighth embodiment will be described. In the eighth embodiment, an articulated robot including a vibration actuator as a driving source will be described.

Fig. 21 is a plan view illustrating a schematic configuration of an articulated robot 505 according to the eighth embodiment. The articulated robot 505 is an example of an articulated robot using an antagonistic drive method. The articulated robot 505 includes a first joint 52, a fixed portion 54, a first pulley 55, a first link 56, a second link 57, a second joint 58, a second pulley 59, a third pulley 60, a wire 51e, and a wire 53e. In the following description, in order to distinguish between a plurality of actuator units 401 provided in the fixed portion 54, the actuator units 401 will be denoted with symbols E1, F1, E2, and F2.

The first joint 52 has a rotational degree of freedom such that the first joint 52 is rotatable around an axis parallel to the z-axis and centered at a point L. The second joint 58 has a rotational degree of freedom such that the second joint 58 is rotatable around an axis parallel to the z-axis and centered at a point M, and is constrained by motion of the first link 56. The first pulley 55, shown by a broken line, is constrained by the first link 56, and is provided to be rotatable around the first joint 52. The second link 57 is provided to be rotatable around the second joint 58 via the second joint 58. The second pulley 59 is constrained by the second link 57. The third pulley 60 is provided to be rotatable around the first joint 52.

The wire 51e is wound around the first pulley 55, one end thereof is linked to the contact body 4 of the actuator unit F1, and the other end thereof is linked to the contact body 4 of the actuator unit E1. The wire 53e is wound around the third pulley 60, one end thereof is linked to the contact body 4 of the actuator unit F2, and the other end thereof is linked to the contact body 4 of the actuator unit E2. A wire 53a has an endless shape (loop shape) and is looped over the second pulley 59 and the third pulley 60.

The actuator units E1 and F1 are each disposed so that the movement direction of the contact body 4 is the y-direction in Figs. 16A to 16D, and drive the wire 51e in the y-direction. When the actuator units E1 and F1 generate thrusts in the y-direction so that the wire 51e may not slacken, a frictional force is generated between the wire 51e and the first pulley 55 due to the difference between the generated thrusts, and it is possible to rotate the first link 56 around the first joint. Thus, the actuator units E1 and F1 can generate a displacement of the first link 56 at an angle θ1 with respect to the x-axis.

Likewise, the actuator units E2 and F2 are each disposed so that the contact body 4 is movable in the x-direction in Fig. 21, and drive the wire 53e in the x-direction. When the actuator units E2 and F2 generate thrusts in the x-direction so that the wire 53e may not slacken, a frictional force is generated between the wire 53e and the third pulley 60 due to the difference between the generated thrusts. Due to the frictional force, the third pulley 60 rotates, the second pulley 59 moves together via the wire 53a, and it is possible to drive the first link 56 and the second link 57 around the first joint 52 and around the second joint 58. That is, it is possible for the vibration actuators E2 and F2 to generate a displacement of the first link 56 at an angle θ1 with respect to the x-axis and to generate a displacement of the second link 57 at an angle θ2 with respect to the first link 56. Moreover, it is also possible to generate only the displacement of the second link 57 at the angle θ2 by driving the vibration actuators E1 and F1 so as to cancel the displacement of the first link 56 at the angle θ1 generated due to driving of the vibration actuators E2 and F2.

In this way, by being driven by the plurality of actuator units 401, the articulated robot 505 can cause a leading end N of the second link 57 to reach a target position in the xy-plane. By performing antagonistic motion in a state in which a tension is constantly applied so that the wires 51e and 53e may not slacken, it is possible to suppress generation of deviation due to wobbling around a joint or buckling of the wires 51e and 53e. As a result, it is possible to increase torsional rigidity around each joint and to position the leading end N with high precision.

Also with the present embodiment, it is possible to reduce the size of the fixed portion 54 by setting the width dimension of the contact body 4 in the x-direction as small as possible and suppressing unnecessary vibration by using the vibration-damping member.

### Ninth Embodiment.

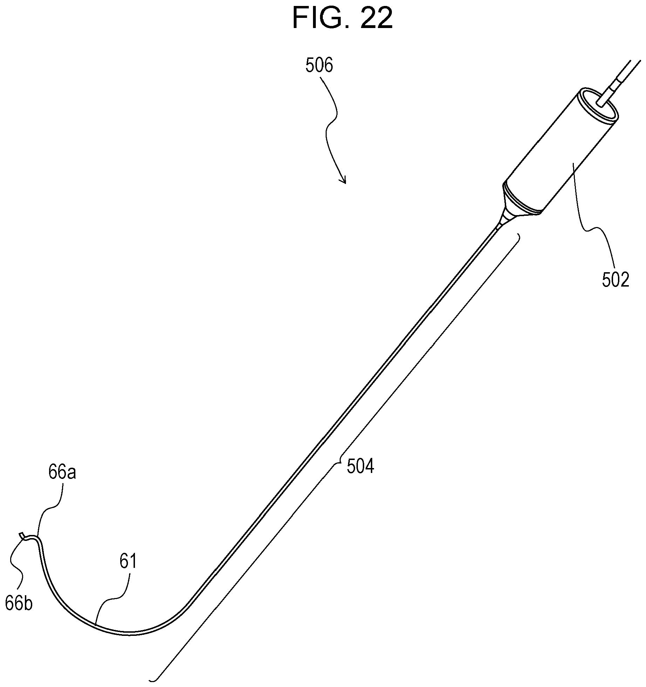

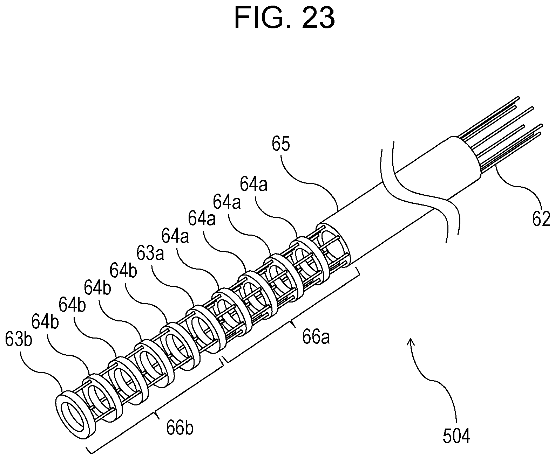

Referring to Figs. 22 and 23, a ninth embodiment will be described. In the ninth embodiment, an articulated robot including a vibration actuator as a driving source will be described.

Fig. 22 is a plan view illustrating a schematic configuration of an articulated robot 506 according to the ninth embodiment. In contrast to the articulated robot 505 according to the eighth embodiment, which operates by using an antagonistic driving method, the articulated robot 506 operates by using a driving method in which a wire is pushed and pulled in a range of thrust such that a wire does not buckle.

The articulated robot 506 includes the apparatus 502 and a wire-driven manipulator 504. Fig. 23 is a perspective view illustrating a schematic configuration of the wire-driven manipulator 504. The wire-driven manipulator 504 is, for example, equivalent to that described in PTL 2. The wire-driven manipulator 504 includes a linear-member guide portion 61 and two bending sections 66a and 66b. A linear member 62 can change the curvatures of the bending sections 66a and 66b by sliding in a hollow portion of a guide tube 65, which is provided in the linear-member guide portion 61, without buckling. The linear-member guide portion 61 may be flexible as illustrated in Fig. 22.

In the wire-driven manipulator 504, three linear members 62 are provided for each bending section. To be specific, among the six linear members 62, leading ends of three linear members are fixed to a guide member 63a, one linear member is fixed to guide members 64a, and the other two linear members are driven to change the curvature of the bending section 66a. Likewise, leading ends of the remaining three linear members 62 are fixed to a leading end member 63b, one of the linear members is fixed to guide members 64b, and the other two linear members are driven to change the curvature of the bending section 66b.

In the articulated robot 506, the apparatus 502 (see Figs. 19A and 19B) is used as a driving source of the wire-driven manipulator 504. The contact bodies 4 of the vibration actuators 201 of the apparatus 502 are linked to the linear members 62, and are used as a driving source for changing the curvatures of the bending sections 66a and 66b of the wire-driven manipulator 504. As with the configuration described with reference to Figs. 19A and 19B, it is desirable that the apparatus 502 be unitized by using an outer member, and thus it is possible to appropriately protect internal components and to improve operability.

With the articulated robot 506, by driving the wire-driven manipulator 504 by using the apparatus 502, it is possible to control the curvatures of the bending sections 66a and 66b with high precision. Moreover, by using the apparatus 502 as a driving portion that drives the wire-driven manipulator 504, it is possible to reduce the size and weight of the driving portion to improve operability. Furthermore, by increasing and decreasing the number of vibration body units in the apparatus 502, it is possible to easily comply with output power required for the bending sections 66a and 66b. In addition, by using a direct-drive vibration actuator to drive the linear member 62 of the wire-driven manipulator 504, it is possible to improve responsivity compared with a case where a driving unit in which an electromagnetic motor and a speed reduction mechanism are combined.

Since the plurality of vibration actuators 201 of the apparatus 502 include a plurality of vibration body units 20 using common components, it is possible to change the output power from each of the vibration actuators 201 by increasing and decreasing the vibration body units 20. Moreover, by changing the amplitude ratio of vibrations in a plurality of vibration modes excited in the vibration body 1, it is also possible to control the magnitude of thrust for driving (deforming) the bending sections 66a and 66b and driving speed. When a voltage is not applied to the electric-mechanical energy conversion element 3, it is possible to maintain the postures of the bending sections 66a and 66b by using a frictional force that acts between the projecting portions 2a and the contact body 4.

Furthermore, by changing the frictional force that acts between the projecting portions 2a and the contact body 4 by driving the vibration body 1 only in the second vibration mode (Fig. 2B), it is possible to provide a setting such that the postures of the bending sections 66a and 66b change in accordance with an external force when the external force acts on the bending sections 66a and 66b. This function can be used, for example, as a safety mechanism for preventing a risk for a human body when the wire-driven manipulator 504 touches the human body. When the vibration body 1 is to be driven only in the second vibration mode (Fig. 2B) to considerably reduce a frictional force between the vibration body 1 and the contact body 4 in this way, it is necessary to set the vibration amplitude to be large. In general, as the vibration amplitude is set to be larger, the vibration amplitude of unnecessary vibration also becomes larger, and this may lead to decrease of output power and generation of large noise.

As described in the embodiments above, by joining the vibration-damping member to a side surface of the contact body, it is possible to suppress unnecessary vibration without increasing the size of the vibration actuator. Thus, by using a vibration actuator according to the present invention, it is possible to realize such a safety mechanism.

The articulated robot 506 is applicable to, for example, an industrial endoscope, a medical endoscope, and a surgical instrument such as a catheter used in medical practices such as treatment, biopsy, and inspection. Although the articulated robot 506 has four degrees of freedom with the two bending sections 66a and 66b, the number of bending sections, that is, the degree of freedom can be set to any appropriate number. At this time, the shape of the support member 360, the diameter g of the pitch circle 370, and the number and the disposition of the vibration actuator 201 may be set to any appropriate conditions with respect to the apparatus 502, in accordance with the number of bending sections and the diameter of the guide member.

For example, although an object to be coupled, which is to be coupled with the vibration body unit via the coupling portion, is another vibration body unit or the support member in the embodiments described above, an object to be coupled is not limited to any of these and may be any portion or component that is movable relative to the contact body. Moreover, although the multi-axis stage 503 and the articulated robots 505 and 506 have been described as examples of an apparatus to which the vibration actuator and the actuator unit according to each of the embodiments are applied, an apparatus to which the vibration actuator and the actuator unit are appliable is not limited to any of these. For example, other examples of an apparatus according to the present invention include: various stage apparatuses for a microscope, a machine tool, and a measurement apparatus; and robots such as a vertical articulated robot, a parallel-link robot, and the like having a larger degree of freedom than the articulated robot 505.

Heretofore, the present invention has been described together with embodiments. However, the embodiments are only concrete examples for carrying out the present invention, and the technological scope the present invention should not be interpreted to be limited by these. That is, the present invention can be carried out in various forms without departing from the technological idea thereof and or the main feature thereof.

The present invention is not limited to the embodiments described above, and can be changed and modified in various ways without departing from the spirit and scope of the present invention. Accordingly, the following claims are attached to disclose the scope of the present invention.

This application claims the benefit of Japanese Patent Application No. 2022-009653 filed January 25, 2022, which is hereby incorporated by reference herein in its entirety. Reference Signs List

1, 81, 98 vibration body
2, 94 elastic body
3, 95 electric-mechanical energy conversion element
4, 91, 74b to 74d, 84a, 84b contact body
24, 24a to 24g, 34, 34a to 34d contact body unit
25, 35, 75a to 75c, 85a, 85b vibration-damping member
26a to 26f, 36a to 36d viscoelastic body
27a to 27d, 37a to 37e reinforcement member
28, 87 displacement-detecting portion
27e, 82 scale
83 detector
5, 11, 21, 22 vibration body unit
8, 18 holding portion
86, 90, 92 outer member
101, 102, 201, 202 vibration actuator
401, 402 actuator unit
501, 502 apparatus
503 multi-axis stage
505, 506 articulated robot

## Claims

1. A vibration actuator comprising:
a vibration body including an elastic body and an electric-mechanical energy conversion element joined to the elastic body; and
a contact body that contacts the vibration body,
wherein the vibration body and the contact body move relative to each other in a predetermined direction, and
wherein a vibration-damping member is provided on a predetermined surface of the contact body that is different from a contact surface that contacts the vibration body.

2. The vibration actuator according to Claim 1, wherein the vibration-damping member includes a viscoelastic body made of a material different from a material of the contact body.

3. The vibration actuator according to Claim 2,
wherein the vibration-damping member includes the viscoelastic body and a reinforcement member, and
wherein the viscoelastic body is interposed between the contact body and the reinforcement member.

4. The vibration actuator according to Claim 3, wherein the vibration-damping member has a multilayer structure in which a plurality of the viscoelastic bodies and a plurality of the reinforcement members are alternately arranged.

5. The vibration actuator according to any one of Claims 1 to 4, wherein the vibration-damping member is provided on both of the predetermined surfaces that face each other.

6. The vibration actuator according to any one of Claims 1 to 5, wherein the vibration-damping member is provided on a side surface connected to the contact surface.

7. The vibration actuator according to any one of Claims 1 to 6, wherein the vibration-damping member is provided on a surface opposite to the contact surface.

8. The vibration actuator according to any one of Claims 1 to 7, wherein an end portion of the vibration-damping member does not protrude further than the contact surface.

9. The vibration actuator according to any one of Claims 1 to 7, wherein an end portion of the vibration-damping member protrudes further than the contact surface.

10. The vibration actuator according to Claim 6, comprising:
a holding portion that holds the vibration body,
wherein a total dimension of the contact body and the vibration-damping member in a direction parallel to the contact surface is less than a dimension of the vibration body or a dimension of the holding portion in the direction parallel to the contact surface.

11. The vibration actuator according to any one of Claims 1 to 10, wherein the contact body is annular.

12. The vibration actuator according to any one of Claims 1 to 11, comprising a positioning structure for positioning the contact body and the vibration-damping member.

13. The vibration actuator according to any one of Claims 1 to 12, comprising:
a displacement-detecting portion that detects relative displacement of the contact body and the vibration body,
wherein the displacement-detecting portion includes a detector that moves together with the contact body or the vibration body and a scale that moves relative to the detector, and
wherein a part of the vibration-damping member constitutes the scale.

14. The vibration actuator according to any one of Claims 1 to 13,
wherein a vibration mode excited in the vibration body is an out-of-plane bending vibration mode in which a plurality of nodal lines are generated in the predetermined direction, and
wherein a sum total of a length of the vibration-damping member in the predetermined direction is greater than or equal to 1/2 of a wavelength of a natural vibration mode excited in the contact body.

15. The vibration actuator according to any one of Claims 1 to 13,
wherein a vibration mode excited in the vibration body is an out-of-plane bending vibration mode in which a plurality of nodal lines are generated in the predetermined direction, and
wherein a sum total of a length of the vibration-damping member in the predetermined direction is greater than or equal to a length of an interval between the nodal lines that are adjacent to each other.

16. The vibration actuator according to any one of Claims 1 to 13,
wherein a vibration mode excited in the vibration body is an out-of-plane bending vibration mode in which a plurality of nodal lines are generated in the predetermined direction, and
wherein a sum total of a length of the vibration-damping member in the predetermined direction is greater than or equal to a center-to-center distance between two projections that are provided on the elastic body and are caused to contact the contact body.

17. The vibration actuator according to any one of Claims 1 to 13,
wherein a vibration mode excited in the vibration body is an out-of-plane bending vibration mode in which a plurality of nodal lines are generated in the predetermined direction, and
wherein the vibration-damping member is provided at a position including an antinode of a natural vibration mode excited in the contact body.

18. The vibration actuator according to any one of Claims 1 to 17, wherein the vibration-damping member is joined to the predetermined surface.

19. A contact body unit comprising:
a contact body that contacts a vibration body; and
a vibration-damping member provided on a predetermined surface of the contact body that is different from a contact surface that contacts the vibration body.

20. An actuator unit, wherein the vibration actuator according to any one of Claims 1 to 18 is unitized by using an outer member, and a part of the contact body or a part of a vibration body unit including the vibration body is led to an outside of the outer member to allow connection of a load.

21. An apparatus comprising the vibration actuator according to any one of Claims 1 to 18.

22. The apparatus according to Claim 21, wherein a plurality of the vibration actuators are arranged radially in a plane perpendicular to the predetermined direction.

23. A multi-axis stage comprising:
the vibration actuator according to any one of Claims 1 to 18;
a fixed portion to which the vibration actuator is fixed; and
a stage that is connected to the contact body and moves in a predetermined direction relative to the fixed portion.

24. An articulated robot comprising the vibration actuator according to any one of Claims 1 to 18 as a driving source.
